# EUROPÄISCHE PATENTSCHRIFT

(11) **EP 0 987 764 B1**
(45) Veröffentlichungstag und Bekanntmachung des Hinweises auf die Patenterteilung: **08.09.2010**
(21) Anmeldenummer: 99118447.4
(22) Anmeldetag: 17.09.1999
(51) Int. Cl.: H01L 27/102, H01L 21/8229

(54) **Elektrisch programmierbare, nichtflüchtige Speicherzellenanordnung**
Electrically programmable non-volatile memory cell arrangement
Arrangement de cellules de mémoire non-volatiles programmables électriquement

(30) Priorität: 18.09.1998 DE 19842883
(43) Veröffentlichungstag der Anmeldung: 22.03.2000
(73) Patentinhaber: Infineon Technologies AG, 85579 Neubiberg (DE)
(72) Erfinder: Stengl, Reinhard, Dr., 86391 Stadtbergen (DE); Schäfer, Herbert, Dr., 85635 Höhenkirchen-Siegertsbrunn (DE); Reisinger, Hans, Dr., 82031 Grünwald (DE); Lehmann, Volker, Dr., 80689 München (DE); Franosch, Martin, 81739 München (DE); Lange, Gerrit, Dr., 81373 München (DE); Wendt, Hermann, Dr., 85630 Grasbrunn (DE)
(74) Vertreter: Viering, Jentschura & Partner

(56) Entgegenhaltungen:
- US-A- 4 677 742
- US-A- 5 416 343
- US-A- 5 536 968
- GRAAF DE C ET AL: "A NOVEL HIGH-DENSITY LOW-COST PROGRAMMABLE READ ONLY MEMORY" INTERNATIONAL ELECTRON DEVICES MEETING (IEDM),US,NEW YORK, IEEE, Seite 189-192 XP000753746 ISBN: 0-7803-3394-2

## Beschreibung

Die Erfindung liegt auf dem Gebiet der Halbleitertechnik und betrifft eine elektrisch programmierbare, nichtflüchtige Speicherzellenanordnung mit einem Halbleitersubstrat, das einen ersten Leitungstyp aufweist,
- bei der zumindest eine erste Adreßleitung und zumindest eine zweite Adreßleitung vorgesehen sind, wobei die zweite Adreßleitung die erste Adreßleitung unter Beabstandung kreuzt,
- bei der sich im wesentlichen zwischen der ersten und der zweiten Adreßleitung eine Speicherzelle befindet, die zumindest teilweise im Halbleitersubstrat angeordnet ist und dort zumindest ein erstes Dotierungsgebiet vom zweiten Leitungstyp unter Bildung eines unmittelbaren Übergangs zwischen den beiden Leitungstypen aufweist, wobei durch diesen Übergang ein elektrischer Stromfluß zwischen der ersten und der zweiten Adreßleitung im Halbleitersubstrat unidirektional begrenzbar ist, und
- bei der sich zumindest eine Zwischenschicht, die Teil der Speicherzelle ist, am Halbleitersubstrat zwischen der ersten und zweiten Adreßleitung befindet,
sowie ein Verfahren zur Herstellung einer derartigen Speicherzellenanordnung.

Bei der Datenverarbeitung werden eine Vielzahl von unterschiedlichen Speichern verwendet. So enthält beispielsweise ein Computer sowohl einen Festwertspeicher (Read Only Memory) ROM als auch einen dynamischen Speicher (Dynamic Random Access Memory) DRAM. DRAM sind sogenannte flüchtige Speicher, bei denen die eingespeicherte Information regelmäßig aufgefrischt werden muß. Im Gegensatz dazu ist bei den sogenannten Festwertspeichern ein Datenauffrischen nicht notwendig, da die Daten permanent eingespeichert sind. Üblicherweise erfolgt die Einspeicherung von Daten in einen Festwertspeicher bereits bei dessen Herstellung. Vorteilhafter sind dagegen jedoch programmierbare Festwertspeicher, bei denen durch geeignete Programmiertechnik die Information erst nach der Herstellung der Festwertspeicher in diese eingeschrieben wird. Derartige Festwertspeicher werden auch als Programmable Read Only Memory (PROM) bezeichnet.

Ein derartiger programmierbarer Festwertspeicher ist beispielsweise in der US-PS 5,536,968 beschrieben. Kern des dortigen Festwertspeichers ist eine Diodenmatrix, bei der jedes Matrizenelement eine Diode und ein thermisches Widerstandselement umfaßt und mit je einer Dateneingangs- und einer Datenausgangsleitung verbunden ist. Die relativ aufwendig ausgeführten und raumgreifenden Widerstandselemente, die die Verbindung zwischen den Dateneingangs- und Datenausgangsleitungen über die Dioden herstellen, können durch einen Stromstoß zum Schmelzen gebracht werden. Dadurch wird die elektrische Verbindung innerhalb eines Matrizenelements unterbrochen und somit dort eine Information eingespeichert. Bei intaktem Widerstandselement weist das Matrizenelement beispielsweise eine logische 1, bei geschmolzenem Widerstandselement dagegen eine logische 0 auf. Diese Information kann nachfolgend durch Prüfen der einzelnen Matrizenelemente abgefragt werden.

Eine Speicherzellenanordnung der eingangs genannten Art ist beispielsweise in der US-PS 4,677,742 offenbart. Bei der dortigen Speicherzellenanordnung sind jeweils zueinander parallel verlaufende erste und zweite Adreßleitungen an einem Halbleitersubstrat angeordnet. Die ersten und zweiten Adreßleitungen kreuzen sich unter Beabstandung durch das Haibleitersubstrat. An den Kreuzungspunkten zwischen den ersten und zweiten Adreßleitungen ist jeweils eine sogenannte PIN-Diode durch aufeinanderfolgendes Abscheiden mehrerer Halbleiterschichten gebildet worden. Weiterhin befindet zwischen jeder Diode und jeweils einer Adreßleitung eine in ihrem Widerstandswert einmal veränderbare Schicht, deren Widerstandswert den Speicherinhalt jeder einzelnen, am Kreuzungsbereich der Adressleitungen sitzenden Speicherzelle bestimmt wird. Ungünstigerweise ist der Platzbedarf dieser Speicherzellenanordnung relativ groß. Wird beispielsweise mit F die kleinste technologisch erreichbare Strukturbreite bezeichnet, so benötigt eine Speicherzelle der in der US-PS 4,677,742 beschriebenen Speicherzellenanordnung eine Fläche von 4 F².

Eine weitere Speicherzellenanordnung wird in de Graaf C et al:"A novel high-density low-cost programmable read only memory", International Electron Devices Meeting (IEDM), US, New York, IEEE, Seite 189-192, XP000753746, ISBN: 0-7803-3394-2 beschrieben, wobei die Speicherfunktion der Speicherzellen auf dem Bilden einer Dioden-Anti-Sicherung infolge eines Gate-Oxid-Durchbruchs basiert.

Eine andere Speicherzellenanordnung wird in US 5,416,343 beschrieben, welche Speicherelemente aufweist, die eine Leiterschicht und eine Halbleiterschicht aufweisen, die voneinander durch eine Isolatorschicht getrennt sind.

Es ist Aufgabe der Erfindung, eine Speicherzellenanordnung mit geringem Platzbedarf der einzelnen Speicherzellen zu schaffen, wobei die Erfindung durch die unabhängigen Anspruche 1 und 16 definiert wird.

Diese Aufgabe wird erfindungsgemäß mit einer Speicherzellenanordnung der eingangs genannten Art dadurch gelöst, dass eine Vielzahl von zueinander parallel verlaufenden Gräben mit dazwischen liegenden Stegen im Halbleitersubstrat vorhanden sind, wobei die Gräben an den Stegen Seitenwände aufweisen und an jeder Seitenwand zumindest zwei erste Adressleitungen längs der Gräben verlaufen. Die Stege sind quer zu den Gräben von Isolationsgebieten durchzogen, die die Stege in einzelne, gegeneinander isolierte Halbleitersubstratgebiete vom ersten Leitungstyp trennen, wobei sich in jedem Halbleitersubstratgebiet zumindest zwei erste Dotierungsgebiete vom zweiten Leitungstyp befinden, die jeweils einer Speicherzelle zugeordnet sind. Jedes Halbleitersubstratgebiet ist mit zumindest einer zweiten Adressleitung verbunden, wobei die zumindest eine zweite Adressleitung quer zu den zumindest zwei ersten Adressleitungen und von diesen beabstandet verläuft.

Gemäß der Erfindung werden die ersten Adressleitungen entlang der Seitenwände der Gräben geführt. Dies eröffnet die Möglichkeit, Speicherzellen mit einem geringeren Platzbedarf herzustellen. Die an den Seitenwänden angeordneten ersten Adressleitungen können im Querschnitt gesehen relativ dünn, dafür jedoch breit, d.h. sich relativ weit in die Tiefe der Gräben erstreckend, ausgeführt werden, ohne das ein zusätzlicher Raumbedarf besteht. Dazu müssen die Gräben nur tief genug ausgebildet sein. Vorteilhaft hierbei ist, dass die relativ breiten ersten Adressleitungen auch bei kleiner Strukturbreite F durch ihre relativ große Querschnittsfläche einen geringen elektrischen Widerstand aufweisen.

Die zumindest zwei ersten Dotierungsgebiete vom zweiten Leitungstyp bilden mit dem Halbleitersubstrat vom ersten Leitungstyp einen unmittelbaren Übergang zwischen den beiden Leitungstypen, wobei durch diesen unmittelbaren Übergang ein elektrischer Stromfluss zwischen den ersten Adressleitungen und der zweiten Aderessleitung im Halbleitersubstrat unidirektional begrenzbar ist. Es befindet sich zumindest einen Zwischenschicht, die Teil der Speicherzelle ist, am Halbleitersubstrat zwischen den ersten Adressleitungen und der zweiten Adressleitung. An jeder Seitenwand der Vielzahl von Gräben sind mindestens zwei erste Adressleitungen angeordnet, die eine erste untere Adressleitung und eine darüber befindliche und von dieser getrennte erste obere Adressleitung umfassen.

Weiterhin ist es günstig, dass an gegenüberliegenden Seitenwänden der Gräben jeweils erste Adressleitungen angeordnet werden können und so in einem Graben mit einer Strukturbreite von 1 F gleichzeitig mindestens vier erste Adressleitungen untergebracht sind. Dadurch verringert sich der Platzbedarf einer einzelnen Speicherzelle zumindest auf F². Wird als technologisch erreichbare Strukturbreite F beispielsweise 0,18 µm zugrunde gelegt, so beträgt der notwendige Platzbedarf nur 0,0324 µm². Damit können pro µm² etwa 30 Bit gespeichert werden.

Bevorzugt bestehen die ersten Adressleitungen aus einem Halbleitermaterial, dass durch einen Dotierstoff vom zweiten Leitungstyp dotiert ist. Als vorteilhaft hat es sich erwiesen, die ersten Adressleitungen aus in situ dotiertem Polysilizium mit einem Dotierstoffgehalt zwischen 10²⁰/cm³ und 10²²/cm³ herzustellen. Als Dotierstoffe werden beispielsweise Arsen beziehungsweise Phosphor zur n-Dotierung verwendet. Selbstverständlich können die ersten Adressleitungen auch eine p-Dotierung aufweisen. Dann ist das Halbleitersubstrat n-leitend.

Der hohe Dotierstoffgehalt sichert einerseits eine gute Leitfähigkeit des Polysiliziums, wodurch die ersten Adressleitungen besonders platzsparend ausgebildet werden können. Andererseits steht durch den hohen Dotierstoffgehalt der ersten Adressleitungen ein großes Reservoir an Dotierstoffen zur Verfügung, das zur Ausbildung des ersten Dotierungsgebiets vom zweiten Leitungstyp beiträgt. Die in den ersten Adressleitungen enthaltenen Dotierstoffe diffundieren, beispielsweise aktiviert durch einen thermischen Prozess, bis zu einem gewissen Grade in das Halbleitersubstrat vom ersten Leitungstyp und bilden dort erste Dotierungsgebiete. Dadurch entsteht im Halbleitersubstrat ein unmittelbarer Übergang zwischen den beiden Leitungstypen, der einen Stromfluss durch diesen hindurch unidirektional begrenzt. Dieser Übergang, beispielsweise ein pn-Übergang, stellt im einfachsten Fall eine Diode dar. Durch die in jeder Speicherzelle angeordnete Diode wird ein Übersprechen auf andere Speicherzellen und andere zweite Adressleitungen vermieden.

Unter einem ersten Leitfähigkeitstyp kann sowohl ein p- als auch ein n-Leiter verstanden werden. Der zweite Leitfähigkeitstyp ist dann jeweils vom entgegengesetzten Typ.

Es hat sich weiterhin als äußerst vorteilhaft erwiesen, dass die ersten Dotierungsgebiete in unmittelbarer Nachbarschaft zu den zugehörigen ersten Adressleitungen entstehen. Damit können die Dotierungsgebiete hinsichtlich der ersten Adressleitungen selbstjustiert und platzsparend ausgebildet werden. Bevorzugt erfolgt auch die Ausbildung der ersten Adressleitungen an den Seitenwänden der Gräben selbstjustiert. Dadurch entstehen die ersten Adressleitungen in Form von selbstjustierten Randstegen. Zusätzliche Maskenschritte entfallen.

Eine vorteilhafte Ausführungsform der Erfindung ist dadurch gekennzeichnet, dass die Zwischenschicht unmittelbar zwischen den ersten Dotierungsgebieten der Speicherzellen und den ersten Adressleitungen an den Seitenwanden der Gräben angeordnet ist.

Die zwischen den ersten Adressleitungen und den ersten Dotierungsgebieten angeordnete Zwischenschicht ist ebenfalls bevorzugt selbstjustiert ausgebildet. Die Diffusion der Dotierstoffe zur Bildung der ersten Dotierungsgebiete durch die Zwischenschicht hindurch wird durch diese nur unwesentlich beeinflusst. Bevorzugt weist die Zwischenschicht eine Stärke zwischen 3 und 20 nm, besonders bevorzugt zwischen 3 und 8 nm auf.

Bevorzugt besteht die Zwischenschicht aus einem Oxid. Oxide, beispielsweise Gate-Oxide, weisen relativ definierte Durchbruchsspannungen auf, so dass durch Anlegen einer geeignet dimensionierten Spannung an die erste und zweite Adressleitung die Zwischenschicht leitfähig gemacht werden kann. Im wesentlichen geschieht dies dadurch, dass sich im Oxid leitfähige Pfade herausbilden. Die Höhe des Spannungsunterschieds zwischen der ersten und zweiten Adressleitung und somit die Stärke des notwendigen Stromimpulses zur Herstellung von leitfähigen Pfaden hängt unter anderem von der Dicke der Zwischenschicht ab. Um übermäßig hohe Spannungen und damit hohe Verlustleistungen zu vermeiden, empfiehlt es sich, die Zwischenschicht ausreichend dünn auszubilden. Ein bevorzugtes Oxid ist beispielsweise Siliziumoxid (SiOx). Der spezifische Widerstand des verwendeten Oxids sollte so hoch sein, dass bei intaktem Oxid eine angelegte Spannung im wesentlichen über dem intaktem Oxid abfällt. Zu berücksichtigen hierbei sind auch alle weiteren und mit dem Oxid in Reihe geschalteten Widerstände (z.B. Gesamtwiderstand, gebildet aus intrinsischem Widerstand der Adressleitungen und des Halbleitersubstrats) sowie der Eingangswiderstand einer nachgeschalteten Messeinrichtung. Im Gegensatz dazu sollte bei elektrisch durchbrochenem Oxid dessen Widerstand nur noch einen geringen Beitrag zum Gesamtwiderstand leisten, so dass die angelegte Spannung am Eingang der Messeinrichtung abfällt. Beträgt beispielsweise der Widerstand des verwendeten Oxids 10¹² Ω/cm, so weist ein 10 nm dickes Oxid einen Widerstand von 10⁶ Ω auf.

Die oben beschriebene Speicherzellenanordnung weist eine Vielzahl von Speicherzellen auf, die sich zumindest teilweise in den einzelnen Halbleitersubstratgebieten befinden. Zu einer Speicherzelle gehört sowohl der im Halbleitersubstratgebiet angeordnete Übergang zwischen den beiden Leitfähigkeitstypen als auch die Zwischenschicht, die sich zwischen dem ersten Dotierungsgebiet und den ersten Adressleitungen befindet. In einem Ersatzschaltbild umfasst somit eine Speicherzelle eine mit einem Kondensator in Reihe geschaltete Diode. Die von der Diode abgewandte Kondensatorelektrode wird bevorzugt von der ersten Adressleitung gebildet. Die Diode, gebildet aus dem ersten Dotierungsgebiet und dem Halbleitersubstratgebiet, gestattet nur einen unidirektionalen Stromfluss. Der durch die Zwischenschicht gebildete Kondensator kann auch als Widerstandselement aufgefasst werden. Durch die ersten und zweiten Adressleitungen werden die jeweiligen Speicherzellen kontaktiert. An jeder Seitenwand der Gräben verlaufen zumindest zwei übereinander angeordnete erste Adressleitungen.

Die Seitenwände der Gräben können entweder senkrecht und damit zueinander parallel verlaufen, oder gegeneinander leicht geneigt sein. Im Hinblick auf eine optimale Raumausnutzung sind jedoch senkrechte Seitenwände zu bevorzugen.

Zum widerstandsarmen Verbinden der Halbleitersubstratgebiete mit den zweiten Adressleitungen weist jedes Halbleitersubstratgebiet zumindest ein zweites Dotierungsgebiet vom ersten Leitungstyp auf. Dieses zweite Dotierungsgebiet ist üblicherweise höher dotiert als das Halbleitersubstratgebiet und weist dadurch gegenüber diesem eine höhere Leitfähigkeit auf. Durch diese Höherdotierung werden beispielsweise gute ohmsche Kontakte zu den zweiten Adressleitungen unter Vermeidung von parasitären Kapazitäten hergestellt.

Bevorzugt ist das Halbleitersubstrat auf einem Grundsubstrat angeordnet. Dieses Grundsubstrat kann entweder ein Isolator oder ein Halbleitermaterial sein. Wird ein Isolator verwendet, so sind die einzelnen, sich bis zum Grundsubstrat erstreckenden Halbleitersubstratgebiete durch dieses Grundsubstrat an ihrer Unterseite gegeneinander isoliert. Seitlich sind die Halbleitersubstratgebiete zum einen durch die Gräben getrennt und zum anderen durch die mit einem isolierenden Material befüllten Isolationsgebiete, die sich quer zu den Gräben erstrecken und diese durchziehen, isoliert. Dadurch wird ein unbeabsichtigtes Kurzschließen der einzelnen Halbleitersubstratgebiete und dadurch von Speicherzellen in benachbarten Halbleitersubstratgebieten verhindert.

Sofern das Grundsubstrat ein Halbleitermaterial ist, erfolgt die Isolation der einzelnen Halbleitersubstratgebiete an ihrer Unterseite bevorzugt durch dritte Dotierungsgebiete vom zweiten Leitungstyp. Diese Dotierungsgebiete befinden sich entweder im Grundsubstrat oder an der zum Grundsubstrat gewandten Seite der Halbleitersubstratgebiete.

In einer bevorzugten Ausführungsform sind die zweiten Adressleitungen am Grundsubstrat angeordnet. Sofern das Grundsubstrat ein Isolator ist, bestehen die zweiten und bevorzugt streifenförmigen Adressleitungen vorzugsweise aus einem leitfähigen Halbleitersubstrat oder aus Metall. Bei Verwendung eines Halbleitermaterials als Grundsubstrat können die zweiten Adressleitungen durch streifenförmige Dotierung in dem Grundsubstrat geschaffen werden. Gegebenenfalls weisen die Halbleitersubstratgebiete an ihrer zum Grundsubstrat gewandten Seite zweite Dotierungsgebiete vom ersten Leitfähigkeitstyp auf, durch die ein widerstandsarmes Verbinden zwischen den zweiten Adressleitungen und den Halbleitersubstratgebieten gewährleistet wird.

Eine weitere vorteilhafte Ausführungsform des Erfindung ist **dadurch gekennzeichnet, dass** die Gräben mit einer isolierenden Schicht befüllt sind, auf der sich die zweiten Adressleitungen befinden.

In diesem Fall sind die zweiten Adressleitungen auf der Oberseite der Halbleitersubstratgebiete angeordnet. Zwischen den zweiten Adressleitungen und den Halbleitersubstratgebieten befindet sich die isolierende Schicht, die bevorzugt planar ausgeführt ist. Zur Reduzierung von Maskenschritten erfolgt die Bildung der zweiten Dotierungsgebiete an der Oberseite der Halbleitersubstratgebiete nach Schaffung von Kontaktlöchern in der isolierenden Schicht. Dies wird dadurch erreicht, dass durch die Kontaktlöcher hindurch die Halbleitersubstratgebiete mit einem Dotierstoff vom ersten Leitfähigkeitstyp dotiert werden. Dadurch bilden sich diese zum einen selbstjustiert und zum anderen mit möglichst geringerem lateralen Platzbedarf heraus. Es ist gegebenenfalls möglich, die Gräben nur bis zu ihrer Oberkante zu befüllen, so dass die Oberseite der Halbleitersubstratgebiete bündig mit den befüllten Gräben abschließt. In diesem Fall sitzen die zweiten Adressleitungen unmittelbar auf den Halbleitersubstratgebieten.

Bevorzugt sind die Speicherzellen in einem Speicherzellenfeld zusammengefasst. Dieses Speicherzellenfeld stellt beispielsweise eine Diodenmatrix dar. Zum Ansteuern der einzelnen Speicherzellen werden die ersten Adressleitungen aus dem Speicherzellenfeld heraus bis zur Peripherie des Halbleitersubstrats geführt. Dort weisen die ersten Adressleitungen individuelle und gegeneinander isolierte Kontaktgebiete auf. Da die ersten Adressleitungen in einem Graben teilweise übereinander geführt werden, müssen die einzelnen Kontaktgebiete nacheinander unter Verwendung entsprechender Masken geätzt werden.

Erfindungsgemäß verlaufen an jeder Seitenwand jedes Grabens mindestens zwei übereinander angeordnete erste Adressleitungen. Dadurch verringert sich der Platzbedarf pro Speicherzelle auf 1 F². Werden dagegen drei Adressleitungen übereinander an jeder Seitenwand entlang geführt, so beträgt der Platzbedarf pro Speicherzelle nur noch 2/3 F². Bei vier Adressleitungen pro Seitenwand verringert sich der Platzbedarf auf 1/2 F². Pro Speicherzelle kann dabei 1 Bit gespeichert werden. Durch die erfindungsgemäße Speicherzellenanordnung kann der benötigte Platzbedarf pro Speicherzelle prinzipiell beliebig verkleinert werden. Grundsätzlich müssen dazu nur die Gräben entsprechend tief geätzt und eine Vielzahl von ersten Adressleitungen an den Seitenwänden ausgebildet werden.

Die Aufgabe, eine Speicherzellenanordnung mit geringem Platzbedarf zu schaffen wird weiterhin durch ein Verfahren mit folgenden Schritten gelöst:
Bereitstellen eines Halbleitersubstrats vom ersten Leitungstyp;
Einbringen von zueinander parallel verlaufenden Isolationsgräben in das Halbleitersubstrat;
Auffüllen der Isolationsgräben mit einem isolierenden Material, so dass Isolationsgebiete in den Isolationsgräben entstehen;
Einbringen von zueinander parallel verlaufenden und senkrecht zu den Isolationsgräben ausgerichteten Gräben in das Halbleitersubstrat, wobei Stege zwischen den Gräben verbleiben, die durch die mit isolierendem Material befüllten Isolationsgräben in einzelne Halbleitersubstratgebiete vom ersten Leitungstyp unterteilt werden;
Bilden einer Zwischenschicht an den Seitenwänden der Gräben; Aufbringen von ersten Adressleitungen vom zweiten Leitungstyp auf die Seitenwände der Gräben, wobei die ersten Adressleitungen einen Dotierstoff vom zweiten Leitungstyp enthalten und wobei an jeder Seitenwand der Gräben mindestens zwei erste Adressleitungen, umfassend eine erste untere Adressleitung und eine darüber befindliche und von dieser getrennte erste obere Adressleitung, ausgebildet werden; und Ausbilden zumindest einer zweiten Adressleitung, wobei die zweite Aderessleitung die ersten Adressleitungen unter Beabstandung kreuzt,
Temperieren des Halbleitersubstrats bei einer vorgegebenen Diffusionstemperatur, so dass der Dotierstoff teilweise aus den ersten Adressleitungen durch die Zwischenschicht hindurch in die Halbleitersubstratgebiete diffundiert und dort Dotierungsgebiete vom zweiten Leitungstyp mit einem unmittelbaren Übergang zum ersten Leitungstyp bildet.

Ein wesentlicher Gedanke der Erfindung ist, dass das erste Dotierungsgebiet selbstjustiert im Halbleitersubstrat ausgebildet wird. Dazu wird ein Halbleitersubstrat vom ersten Leitungstyp, an dem eine erste Adressleitung vom zweiten Leitungstyp angeordnet ist, einem Temperaturschritt unterzogen. Die in der ersten Adreßleitung enthaltenen Dotierstoffe vom zweiten Leitungstyp diffundieren bei diesem Diffusionsschritt durch die Zwischenschicht hindurch in das Halbleitersubstratgebiet und bilden dort ein erstes Dotierungsgebiet vom zweiten Leitungstyp. Die Temperierung, bzw. der Diffusionsschritt, wird dabei über eine vorbestimmte Zeitdauer und bei einer vorgegebenen Diffusionstemperatur durchgeführt. Die Zeitdauer und die Diffusionstemperatur sind dabei bevorzugt so aufeinander abgestimmt, daß sich das erste Dotierungsgebiet bis zu einer gewünschten Tiefe im Halbleitersubstrat ausbildet. Dadurch entsteht gleichzeitig ein unmittelbarer Übergang vom zweiten Leitungstyp zum ersten Leitungstyp, der als Diodenübergang einen Stromfluß unidirektional sperrt.

Zur Herstellung der Speicherzellenanordnung werden zunächst in das Halbleitersubstrat vom ersten Leitungstyp zueinander parallel verlaufende Isolationsgräben in das Halbleitersubstrat eingebracht und nachfolgend mit einem isolierenden Material aufgefüllt. Die so aufgefüllten Isolationsgräben stellen die Isolationsgebiete dar. Anschließend werden quer zu den Isolationsgräben verlaufende Gräben in das Halbleitersubstrat eingeätzt, wobei zwischen den Gräben Stege verbleiben. Die Breite der Stege, der Gräben sowie der Isolationsgräben entspricht bevorzugt jeweils der Strukturbreite 1 F. Die Stege werden durch die zuvor gebildeten Isolationsgebiete in einzelne Halbleitersubstratgebiete vom ersten Leitungstyp unterteilt. Der Querschnitt eines einzelnen Halbleitersubstratgebiets, gesehen von oben auf das Halbleitersubstrat, beträgt somit 1 F². Nachdem die einzelnen und gegeneinander isolierten Halbleitersubstratgebiete geschaffen wurden, erfolgt die Ausbildung einer Zwischenschicht an den Seitenwänden der Gräben in Form eines selbstjustierten Randstegs. Dies wird beispielsweise durch konformes Abscheiden und nachfolgendes anisotropes Ätzen eines Oxids erreicht. Das Oxid wird vergleichsweise dünn, bevorzugt zwischen 3 nm und 10 nm aufgetragen. Nach Bildung der Zwischenschicht schließt sich das Aufbringen von ersten Adreßleitungen vom zweiten Leitungstyp auf die Seitenwände der Gräben an. Bevorzugt werden an jeder Seitenwand der Gräben zumindest eine erste untere Adreßleitung und eine darüber angeordnete und von der ersten unteren Adreßleitung getrennte erste obere Adreßleitung gebildet. Diese Adreßleitungen werden ebenfalls als selbstjustierte Randstege geformt. Dazu wird bevorzugt eine in situ dotierte Polysiliziumschicht konform auf das Halbleitersubstrat abgeschieden. Die Materialstärke dieser Polysiliziumschicht richtet sich nach der angestrebten technologischen Strukturbreite F. Auf jeden Fall sollte die Dicke der Polysiliziumschicht kleiner als F/2 sein. Nach dem anisotropen Ätzen der Polysiliziumschicht zur Bildung der Adreßleitungen in Form von selbstjustierten Randstegen, wird das Halbleitersubstrat bei einer vorgegebenen Diffusionstemperatur wärmebehandelt. Dabei werden die Dotierstoffe in den Adreßleitungen aktiviert und diffundieren gleichzeitig durch die Zwischenschicht hindurch in die Halbleitersubstratgebiete und bilden dort die ersten Dotierungsgebiete vom zweiten Leitungstyp. Dadurch werden unidirektional sperrende Übergänge zwischen Gebieten vom ersten und vom zweiten Leitungstyp gebildet.

Bevorzugt wird das Halbleitersubstrat vor seiner Strukturierung epitaktisch auf einem Grundsubstrat aufgebracht. Dieses Grundsubstrat kann beispielsweise ein Halbleitermaterial sein. Zur Isolierung der Halbleitersubstratgebiete in ihrer, dem Grundsubstrat zugewandten Seite werden dort Dotierungsgebiete vom zweiten Leitfähigkeitstyp ausgebildet. Dadurch entsteht ein zweiter unmittelbarer Übergang vom ersten Leitfähigkeitstyp zum zweiten Leitfähigkeitstyp in den einzelnen Halbleitersubstratgebieten. Sind das Grundsubstrat und die Halbleitersubstratgebiete beispielsweise p-leitend, wird durch das n-leitende Dotierungsgebiet an der zum Grundsubstrat weisenden Seite des Halbleitersubstratgebiets ein pnp-Übergang geschaffen, der einen Stromfluß in beiden Richtungen behindert. Dadurch werden die einzelnen Halbleitersubstratgebiete wirkungsvoll gegeneinander isoliert.

Günstig ist es auch, bei einem Grundsubstrat vom zweiten Leitfähigkeitstyp, d.h. bei gegenüber den Halbleitersubstratgebieten entgegengesetztem Leitfähigkeitstyp, die zweiten Adreßleitungen im Grundsubstrat auszubilden. Diese weisen dann den ersten Leitfähigkeitstyp auf und sind unmittelbar mit den Halbleitersubstratgebieten verbunden. Durch das Grundsubstrat vom zweiten Leitfähigkeitstyp werden dagegen die quer zu den zweiten Adreßleitungen liegenden einzelnen Halbleitersubstratgebiete wirkungsvoll gegeneinander isoliert, da sich zwischen benachbarten Adreßleitungen jeweils zwei entgegengesetzt gerichtete Übergänge herausbilden.

Wird als Grundsubstrat ein Isolationsmaterial verwendet, bedarf es keiner weiteren Isolation der einzelnen Halbleitersubstratgebiete gegeneinander. Vielmehr können hier in einfacher Art und Weise zweite Adreßleitungen auf das Grundsubstrat aufgebracht werden, die mit den darüber angeordneten Halbleitersubstratgebieten einen unmittelbaren Kontakt aufweisen.

Sofern die zweiten Adreßleitungen oberhalb der Halbleitersubstratgebiete angeordnet werden, wird vor deren Bildung eine planare, isolierende Schicht auf die Gräben und die Stege aufgebracht. Nachfolgend werden in der isolierenden Schicht bis zu den Halbleitersubstratgebieten reichende Kontaktlöcher geätzt, durch die hindurch ein Dotierstoff vom ersten Leitungstyp in die Halbleitersubstratgebiete eingebracht wird. Durch diesen Dotierungsschritt verbessern sich die Kontakteigenschaften zwischen den Halbleitersubstratgebieten und einem die Kontaktlöcher auffüllenden leitfähigen Material. Bevorzugt werden die Kontaktlöcher gleichzeitig mit dem Abscheiden der zweiten Adreßleitungen auf die isolierende Schicht befüllt. Als Material eignet sich beispielsweise in situ dotiertes Polysilizium, Aluminium oder eine Aluminium-Kupfer-Legierung.

Die in einem Speicherzellenfeld zusammengefaßten Speicherzellen sind weiterhin bevorzugt über die bis zur Peripherie des Speicherzellenfeldes führenden Adreßleitungen adressierbar. Dazu werden die konform abgeschiedenen ersten Adreßleitungen, die zunächst noch unstrukturiert sind, an der Peripherie des Speicherzellenfeldes mit einer geeigneten Fototechnik strukturiert, so daß einzelne, voneinander isolierte Kontaktgebiete geschaffen werden. Dabei ist je ein Kontaktgebiet mit je einer ersten Adreßleitung verbunden. Zum Auftrennen der sich in einer gemeinsamen Ebene befindenden ersten unteren Adreßleitungen werden Trimm-Masken verwendet. Strukturgleiche Trimm-Masken können auch zum Auftrennen der oberen ersten Adreßleitungen verwendet werden.

Zum Kontaktieren der zweiten Adreßleitungen werden keine zusätzlichen Masken benötigt, da diese zweiten Adreßleitungen bevorzugt nebeneinander und nicht wie die ersten Adreßleitungen übereinander geführt werden.

Im folgenden wird die Erfindung anhand eines Ausführungsbeispiels beschrieben und in Figuren schematisch dargestellt.

Es zeigen:
- Fig.1:: Ein Schaltbild einer erfindungsgemäßen Speicherzellenanordnung,
- Fig.2:: eine räumliche Ansicht einer mit Gräben versehenen Speicherzellenanordnung,
- Fig.3a-3h:: verschiedene Verfahreneschritte zur Herstellung einer Speicherzellenanordnung,
- Fig.4a-4c:: weitere Verfahrensschritte zur Herstellung einer Speicherzellenanordnung,
- Fig.5-7:: unterschiedliche Ausbildungen des Grundsubstrats, und
- Fig.8-9:: unterschiedliche Möglichkeiten zum Kontaktieren der ersten Adreßleitungen.

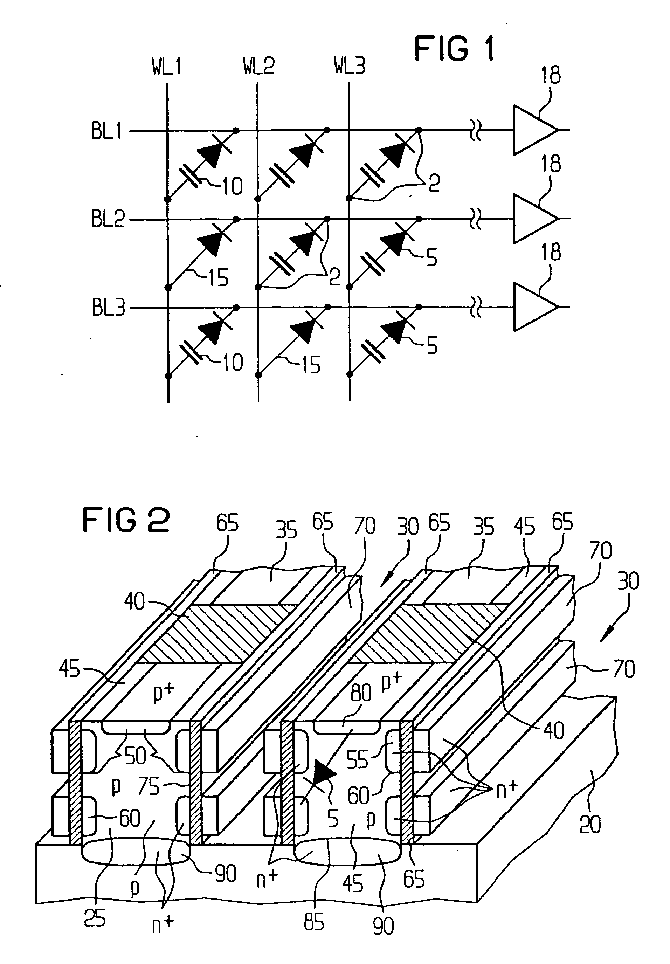

In Figur 1 ist der prinzipielle Aufbau einer erfindungsgemäßen Speicherzellenanordnung in einem Schaltbild dargestellt. Grundsätzlich weist die Speicherzellenanordnung eine Vielzahl von sich kreuzenden Adreßleitungen auf, wobei die ersten Adreßleitungen hier beispielhaft mit Wortleitung 1 bis 3 (WL 1...3) und die zweiten Adreßleitungen mit Bitleitung 1 bis 3 (BL1...3) bezeichnet sind. Im Kreuzungsbereich der einzelnen Wort- und Bitleitungen befindet sich jeweils eine Speicherzelle 2, die durch eine Diode 5 und einen Kondensator 10 repräsentiert ist. Durch die Diode 5 wird ein Stromfluß zwischen Wort- und Bitleitung unidirektional begrenzt, so daß zum Beispiel nur ein Stromfluß von der Wort- zu der Bitleitung, nicht jedoch umgekehrt erfolgen kann. Dadurch wird ein fehlerhaftes Auslesen des Speicherinhalts der einzelnen Speicherzellen 2 über nicht adressierte Speicherzellen 2 verhindert. Sofern in den einzelnen Speicherzellen noch keine Daten eingeschrieben wurden, sperren die Kondensatoren jeglichen Stromfluß zwischen Bit- und Wortleitung und repräsentieren damit z.B. eine logische 0. Durch Anlegen einer Überspannung an die einzelnen Kondensatoren 10 können diese jedoch elektrisch durchbrochen und somit ein Stromfluß ermöglicht werden. Dadurch wird gleichzeitig der Speicherinhalt jeder Speicherzelle 2 verändert. Repräsentiert ein intakter Kondensator 10 den logischen Wert 0, so repräsentiert ein elektrisch durchbrochener Kondensator 10 den logischen Wert 1. Wird beispielsweise als Kondensatordielektrikum ein Oxid verwendet, so sperrt ein intaktes Oxid einen Stromfluß zwischen Wort- und Bitleitung und repräsentiert dadurch den logischen Wert 0. Nach Zerstörung des Oxids kann ein Strom zwischen Wort- und Bitleitung fließen, was einer logischen 1 entspricht. Ein durchbrochenes Oxid ist durch eine direkte Verbindung 15 zwischen Diode 5 und der Wortleitung gekennzeichnet. Der Stromfluß zwischen Wort- und Bitleitung läßt sich durch geeignete und mit den Bitleitungen verbundene Verstärkerelemente 18 messen und weiterverarbeiten.

Als Kondensatordielektrikum wird beispielsweise Siliziumoxid (SiO₂) verwendet. Dieses weist eine Durchbruchsladung von etwa 10 Coulomb/cm² auf. Bei einer angelegten Spannung von 10 V an ein Kondensatordielektrikum mit einer Stärke von 10 nm (resultierende Feldstärke 10 MV/cm) fließt ein Strom von etwa 1 mA/cm², der sich um jeweils eine Dekade pro 1 V erhöht. Somit ergibt sich bei 10 V eine Programmierzeit zum Programmieren einer Speicherzelle von etwa 1000 sec, oder von 1 msec bei 16 V. Günstiger ist jedoch, das Kondensatordielektrikum dünner auszubilden, um die beim elektrischen Durchbruch auftretende hohe Verlustleistung zu verringern. Beispielsweise kann eine Speicherzellenanordnung mit einem 3 bis 4 nm dicken Kondensatordielektrikum mit etwa 1,5 V betrieben werden. Bei dieser Spannung erfolgt noch kein Durchbruch des Kondensatordielektrikums, so daß 1,5 V ausreichend sind, um Daten aus der Speicherzelle auszulesen. Das Einspeichern der Daten erfolgt etwa mit 5 V, wobei ein Zellenstrang einer Speicherzellenanordnung etwa innerhalb 1 msec programmiert werden kann. Die dabei auftretende Verlustenergie pro cm² Kondensatordielektrikum beträgt dann etwa 50 Wsec (10 Coulomb * 5 V). Ist die erwünschte Verlustleistung etwa 0,5 W, werden für ein 1 Gigabit-Speicher etwa 100 sec zum Programmieren benötigt. Bei höheren erlaubten Verlustleistungen kann das Programmieren entsprechend schneller erfolgen. Die erfindungsgemäße Speicherzellenanordnung gestattet daher ein relativ einfaches und schnelles Abspeichern großer Datenmengen. Die Größe der Speicherzellenanordnung, das heißt ihre Speicherkapazität, kann der jeweiligen Applikation angepaßt werden. So ist es auch möglich, eine Speicherzellenanordnung mit einer Kapazität größer als einem Gigabit herzustellen.

Der Aufbau einer erfindungsgemäßen Speicherzellenanordnung ist in Figur 2 dargestellt. Auf einem Grundsubstrat 20 ist ein Halbleitersubstrat 25 angeordnet. In diesem verlaufen einzelne Gräben 30, zwischen denen sich Stege 35 befinden. Die Stege 35 sind periodisch von Isolationsgebieten 40 unterbrochen, die die Stege 35 in einzelne Halbleitersubstratgebiete 45 unterteilen. Jedes etwa würfelförmige Halbleitersubstratgebiet 45 beherbergt vier Speicherzellen 50, die jeweils eine Diode 5 und einen Kondensator, hier nicht dargestellt, umfassen. Jede Diode 5 wird durch einen n⁺p-Übergang 60 repräsentiert. Dabei ist das Halbleitersubstratgebiet 45 p-leitend, in das ein hochdotiertes n-leitendes Gebiet 55 eingebracht ist. Zwischen dem n-leitenden Gebiet 55, das hier das erste Dotierungsgebiet 55 darstellt, und dem p-leitenden Halbleitersubstratgebiet 45 wurde somit ein unmittelbarer Übergang 60 vom n- zum p-leitenden Gebiet geschaffen. Der Kondensator jeder Speicherzelle 50 besteht aus dem n-leitenden Gebiet 55, einer Zwischenschicht 65, die hier ein Kondensatordielektrikum darstellt, und einer ersten Adreßleitung 70. Die Zwischenschicht 65 befindet sich an der Seitenwand 75 des Grabens 30, an der auch die ersten Adreßleitungen 70 verlaufen. Im Hinblick auf den Kondensator bildet somit die erste Adreßleitung 70 gleichzeitig eine erste Kondensatorelektrode, die Zwischenschicht 65 das Kondensatordielektrikum und das n-leitende Gebiet 55 die zweite Kondensatorelektrode.

Weiterhin ist jedes Halbleitersubstratgebiet 45 mit einer hier nicht dargestellten zweiten Adreßleitung über ein hochdotiertes p-leitendes zweites Dotierungsgebiet 80 kontaktiert. Die Zwischenschicht 65 kann lokal durch Anlegen einer Überspannung zerstört werden. Um dies zu erreichen, wird an jeweils einer ausgewählten ersten Adreßleitung 70 und einer ausgewählten zweiten Adreßleitung eine geeignet dimensionierte Überspannung angelegt. Dadurch wird in der jeweils adressierten Speicherzelle 50 die Zwischenschicht 65 lokal in ihrer Leitfähigkeit verändert und somit ein Stromfluß zwischen der ersten Adreßleitung 70 und der zweiten Adreßleitung ermöglicht.

Zur Isolation der einzelnen Halbleitersubstratgebiete 45 an ihrer zum Grundsubstrat 20 gewandten Seite 85 sind hochdotierte n-leitende dritte Dotierungsgebiete 90 im Grundsubstrat 20 angeordnet, die sich teilweise bis in die einzelnen Halbleitersubstratgebiete 45 hinein erstrecken.

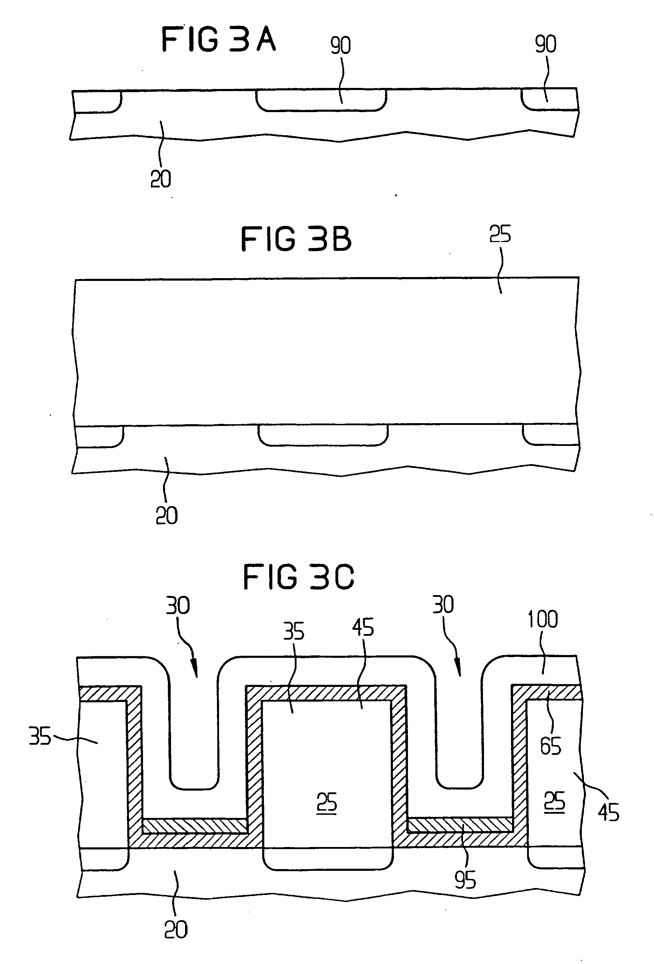

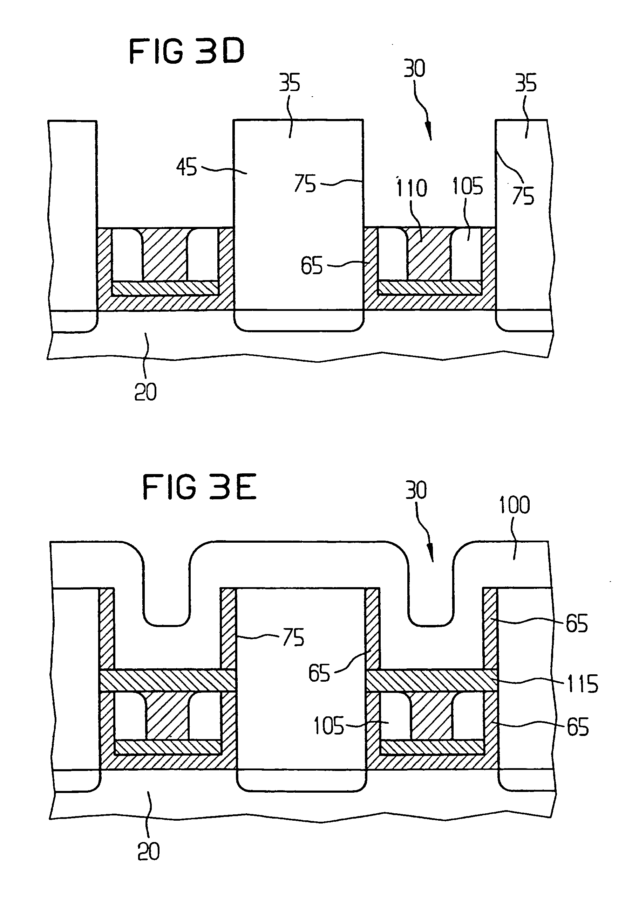

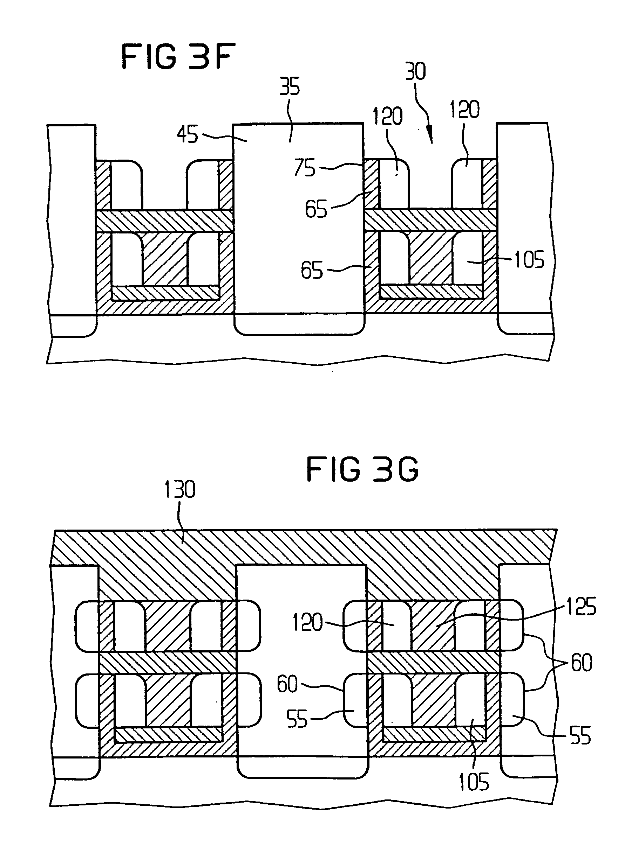

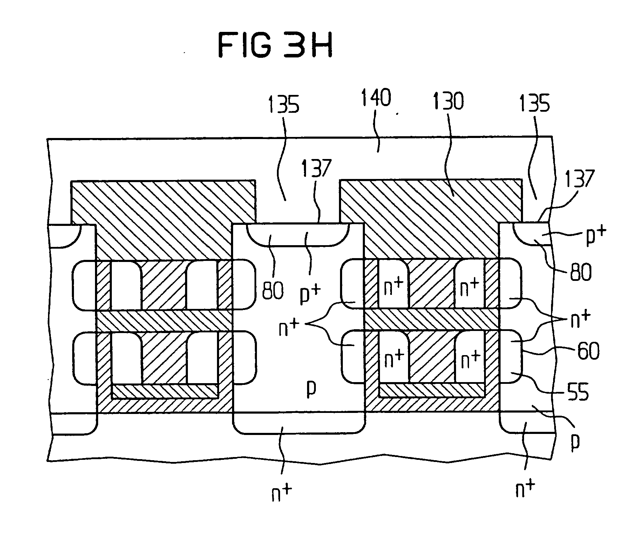

Im folgenden soll das erfindungsgemäße Verfahren zur Herstellung einer Speicherzellenanordnung beschrieben werden. Dazu wird auf die Figuren 3a bis 3h verwiesen. Zunächst wird ein Grundsubstrat 20 mit integrierten dritten Dotierungsgebieten 90 bereitgestellt. Die dritten Dotierungsgebiete 90 sind entsprechend der nachfolgend zu bildenden Gräben und Stege in ihrer Größe und ihrem seitlichen Abstand zueinander angepaßt. Das Grundsubstrat 20 ist in diesem Ausführungsbeispiel ein Halbleiter.

Nachfolgend wird ein Halbleitersubstrat 25, bevorzugt in situ p-dotiertes Silizium, epitaktisch auf das Grundsubstrat 20 abgeschieden. Danach werden mittels geeigneter Maskentechnik Isolationsgräben in das Halbleitersubstrat 25 eingearbeitet und mit einem isolierenden Material befüllt. Dieser Verfahrensschritt wird jedoch erst in nachfolgenden Figuren genauer beschrieben. Nachdem die Isolationsgräben geschaffen wurden, erfolgt mittels Maskentechnik das Einätzen der Gräben 30 in das Halbleitersubstrat 25. Daran schließt sich ein konformes Aufbringen der Zwischenschicht 65 an. Bevorzugt wird nachfolgend ein CVD-Oxid 95, bevorzugt TEOS, in den unteren Bereich der Gräben 30 abgeschieden, gefolgt von einem konformen Auftragen einer in situ n-dotierten Polysiliziumschicht 100 auf die Zwischenschicht 65. Die so erhaltene Struktur ist in Figur 3c dargestellt. Anschließend werden die Polysiliziumschicht 100 und die Zwischenschicht 65 bis etwa zur halben Höhe der Gräben 30 anisotrop zurückgeätzt. Dadurch entstehen an den Seitenwänden 75 jedes Grabens 30 erste untere Adreßleitungen 105 sowie die zwischen den ersten unteren Adreßleitungen 105 und der Seitenwand 75 angeordnete Zwischenschicht 65. Die verbleibenden Hohlräume zwischen den ersten unteren Adreßleitungen 105 lassen sich mit einem thermischen Oxid 110 planarisieren. Nachfolgend wird, wie in Figur 3e dargestellt, zunächst ein weiteres Oxid 115 zum Bedecken der ersten unteren Adreßleitungen 105 und der Zwischenschicht 65 aufgetragen. Daran schließt sich das selbstjustierte Ausbilden (konformes Abscheiden mit nachfolgendem anisotropen Ätzen) der Zwischenschicht 65 an den Seitenwänden 75 im oberen Bereich des Grabens 30 an, auf die eine weitere Polysiliziumschicht 100 aufgetragen wird. Nach einem anisotropen Zurückätzen der Polysiliziumschicht 100 sind nun im oberen Teil des Grabens 30 erste obere Adreßleitungen 120 selbstjustierend entstanden. Die erhaltene Struktur ist in Figur 3f dargestellt.

Die verbleibenden Hohlräume werden mit einem Oxid 125 sowie mit einer planaren isolierenden Schicht 130 aufgefüllt, wobei die isolierende Schicht 130 die Gräben 30 und die zwischen den Gräben 30 angeordneten Stege 35 vollständig bedeckt. Durch einen nachfolgenden Temperaturschritt diffundieren die in der Polysiliziumschicht 100, bzw. in den ersten oberen und unteren Adreßleitungen 120 und 105, enthaltenen Dotierstoffe teilweise durch die Zwischenschicht 65 hindurch in die Halbleitersubstratgebiete 45. Dabei entstehen die ersten Dotierungsgebiete 55, die gegenüber den Halbleitersubstratgebieten 45 vom zweiten Leitfähigkeitstyp sind. Der sich dabei herausbildende unmittelbare Übergang 60 zwischen den ersten Dotierungsgebieten 55 und den Halbleitersubstratgebieten 45 wirkt als sperrender pn-Übergang. Zur Ausbildung der ersten Dotierungsgebiete 55 benötigt man bei einer etwa 4 nm dicken Zwischenschicht aus Siliziumoxid (SiO₂) bei 1000° C etwa 60 min. Weisen die ersten Adreßleitungen 70, 105 und 120 eine Dotierstoffkonzentration zwischen 10²¹ und 10²²/cm³ auf, so beträgt bei obigen Prozeßparametern die Ausdehnung der ersten Dotierungsgebiete 55 innerhalb der Halbleitersubstratgebiete 45 etwa 30 bis 50 nm, wobei als Grenze ein Abfall der Dotierstoffkonzentration um 3 Dekaden gegenüber der Dotierstoffkonzentration in den ersten Adreßleitungen 70, 105 und 120 zugrunde gelegt wurde. Diese Messungen wurden mittels Secondary Ion Mass Spectroscopy verifiziert.

In diesem Ausführungsbeispiel ist die Zwischenschicht 65 unterhalb der ersten oberen und ersten unteren Adreßleitung 105 und 120 durch zweimaliges Abscheiden entstanden. Dabei wurde zunächst die Zwischenschicht 65 für die ersten unteren Adreßleitungen 105 und nachfolgend für die ersten oberen Adreßleitungen 120 geschaffen. Das zweimalige Auftragen der Zwischenschicht 65 empfiehlt sich, da beim Ätzen der Polysiliziumschicht 100 zur Bildung der ersten unteren Adreßleitungen 105 die bereits abgeschiedene Zwischenschicht 65 angegriffen wird.

In einem abschließenden Verfahrensschritt werden zunächst Kontaktlöcher 135 in der isolierenden Schicht 130 gebildet. Durch diese hindurch können nun die Halbleitersubstratgebiete 45 an ihrer Oberseite 137 kontaktiert werden. Zum Bereitstellen eines möglichst widerstandsarmen Kontakts werden dazu zunächst die Halbleitersubstratgebiete 45 an ihrer Oberseite 137 mit einem hochdotierten zweiten Dotierungsgebiet 80, welches den gleichen Leitungstyp wie die Halbleitersubstratgebiete 45 aufweist, versehen. Bevorzugt erfolgt die Bildung dieser zweiten Dotierungsgebiete 80 mittels Ionenimplantation durch die Kontaktlöcher 135 hindurch. Dadurch werden keine weiteren Masken benötigt. Anschließend werden die Kontaktlöcher 135 mit einem leitfähigen Material befüllt. Bevorzugt werden dazu auf die isolierende Schicht 130 die zweiten Adreßleitungen 140 aufgebracht, die dabei gleichzeitig die Kontaktlöcher 135 füllen und so die Halbleitersubstratgebiete 45 über die zweiten Dotierungsgebiete 80 kontaktieren.

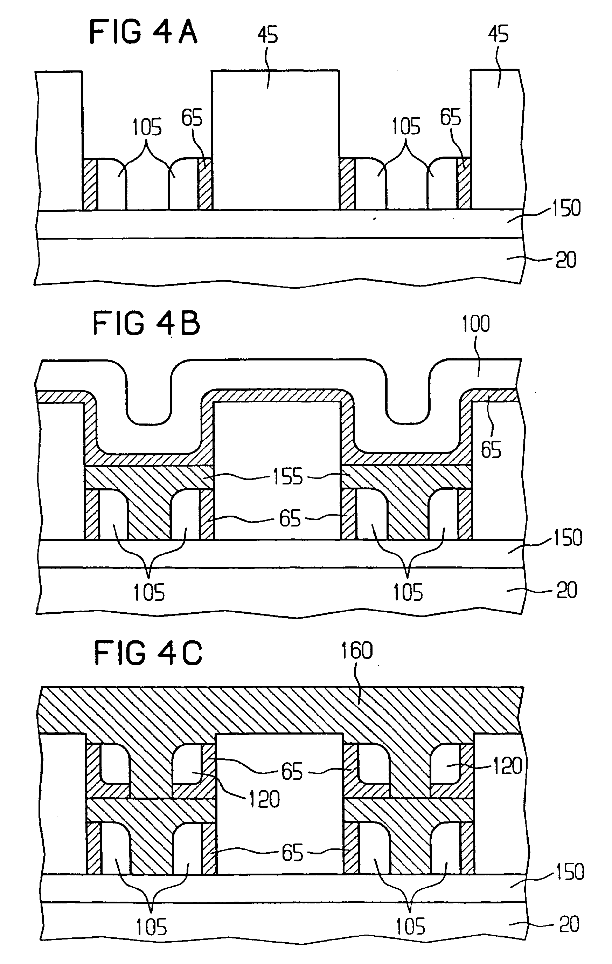

Eine weitere bevorzugte Ausführungsform des Herstellungsverfahrens ist in den Figuren 4a - 4c dargestellt. Das Grundsubstrat 20 weist hierbei an seiner Oberseite eine Isolationsschicht 150 zum Isolieren der einzelnen Halbleitersubstratgebiete 45 auf. Diese werden, wie bereits beschrieben, durch epitaktischen Auftrag eines Halbleitersubstrats 25 und nachfolgendes Ätzen geschaffen. Durch Verwendung der Isolationsschicht 150 kann auf das Abscheiden eines Oxids an der Unterseite der Gräben 30 verzichtet werden. Somit können sowohl die Zwischenschicht 65 als auch die Polysiliziumschicht 100 unmittelbar in den Gräben 30 abgeschieden und anisotrop geätzt werden. In Form von randseitigen Stegen ausgebildete erste untere Adreßleitungen 105 sind in der Figur 4a dargestellt. Nachfolgend werden die verbleibenden Hohlräume mit einem Oxid 155 aufgefüllt und die ersten unteren Adreßleitungen 105 dabei vollständig bedeckt. Nun erfolgt das Abscheiden der Zwischenschicht 65 und der Polysiliziumschicht 100 auf die etwa bis zur Hälfte gefüllten Gräben 30. Die Polysiliziumschicht 100 und die Zwischenschicht 65 werden nun gemeinsam anisotrop geätzt. Die erhaltene und mit einem weiteren Oxid 160 planarisierte Struktur ist in Figur 4c dargestellt.

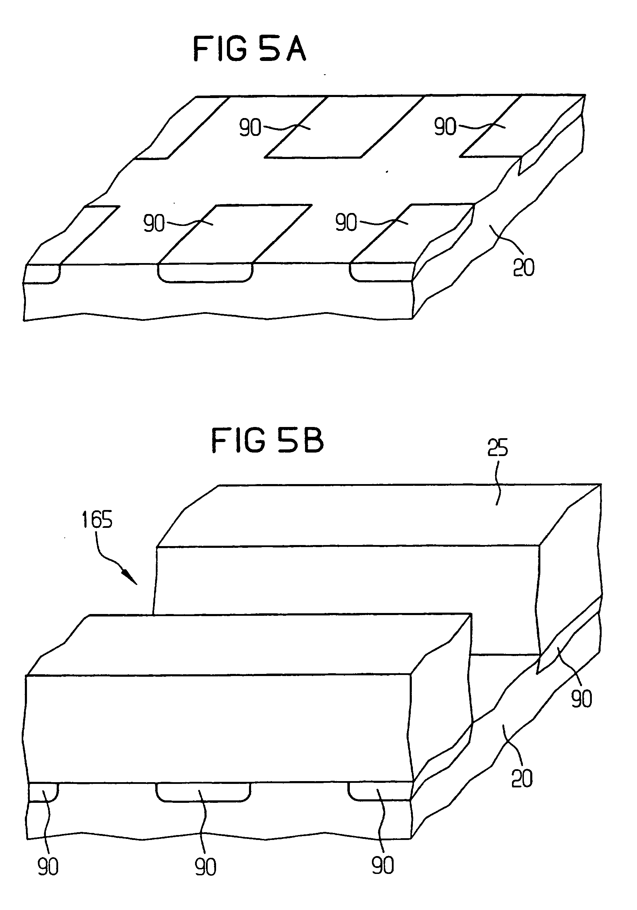

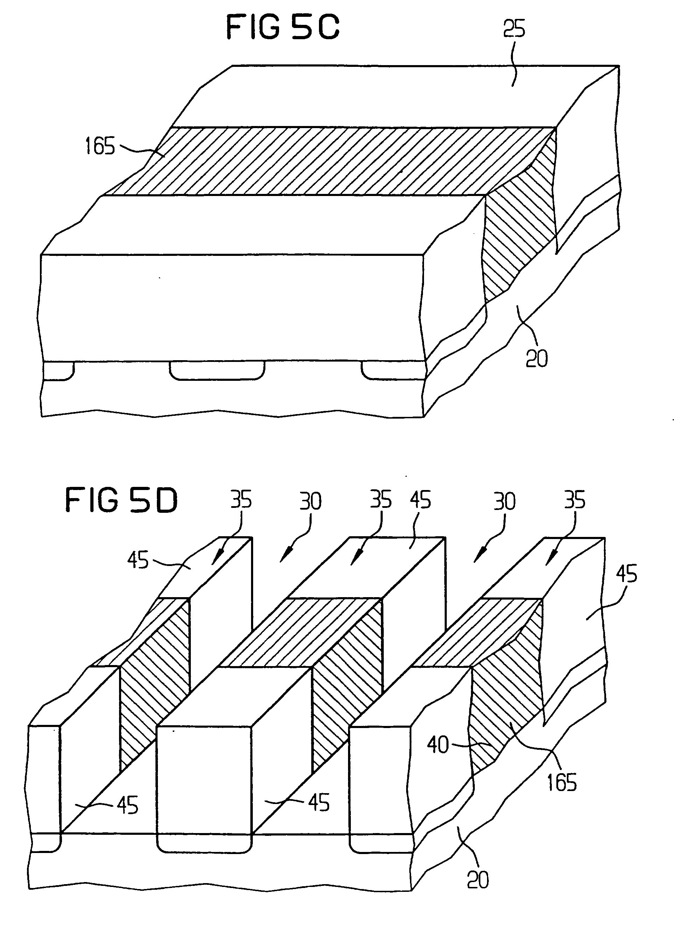

Im folgenden sollen bevorzugte Ausführungen des Grundsubstrats beschrieben werden. Ausgehend von der Figur 5a, in der ein Grundsubstrat 20 mit integrierten Dotierungsgebieten 90 dargestellt ist, wird zunächst ein Halbleitersubstrat 25 auf das Grundsubstrat 20 aufgebracht. Danach werden die Isolationsgräben 165, die quer zu den später zu schaffenden Gräben 30, verlaufen in das Halbleitersubstrat 25 anisotrop eingeätzt. Nach einem planarisierenden Befüllen der Isolationsgräben 165 mit einem isolierenden Material, wodurch die Isolationsgebiete 40 entstehen, werden die Gräben 30 geschaffen. Zwischen diesen verbleiben die Stege 35, die periodisch von den Isolationsgebieten 40 durchzogen sind. Aus dem Halbleitersubstrat 25 wurden somit durch das gekreuzte Einbringen der Isolationsgräben 165 und der Gräben 30 gegeneinander isolierte Halbleitersubstratgebiete 45 geschaffen, zwischen denen sich die einzelnen Halbleitersubstratgebiete 45 befinden. In einer Richtung sind diese jeweils von den die Gräben 30, in der anderen Richtung von den Isolationsgebieten 40 begrenzt. Die Grundfläche der Halbleitersubstratgebiete 45 beträgt 1 F², sofern mit F die kleinste technologisch erreichbare Strukturbreite (im wesentlichen durch die verwendeten Lithografieverfahren bestimmt) bezeichnet wird. Die Tiefe der einzelnen Gräben 30 hängt von der Anzahl der einzubringenden ersten Adreßleitungen 70 ab. Bevorzugt weisen die Isolationsgräben 165 und die Gräben 30 die gleiche Tiefe auf, das heißt, sie wurden bis zum Grundsubstrat 20 in das Halbleitersubstrat 25 eingeätzt.

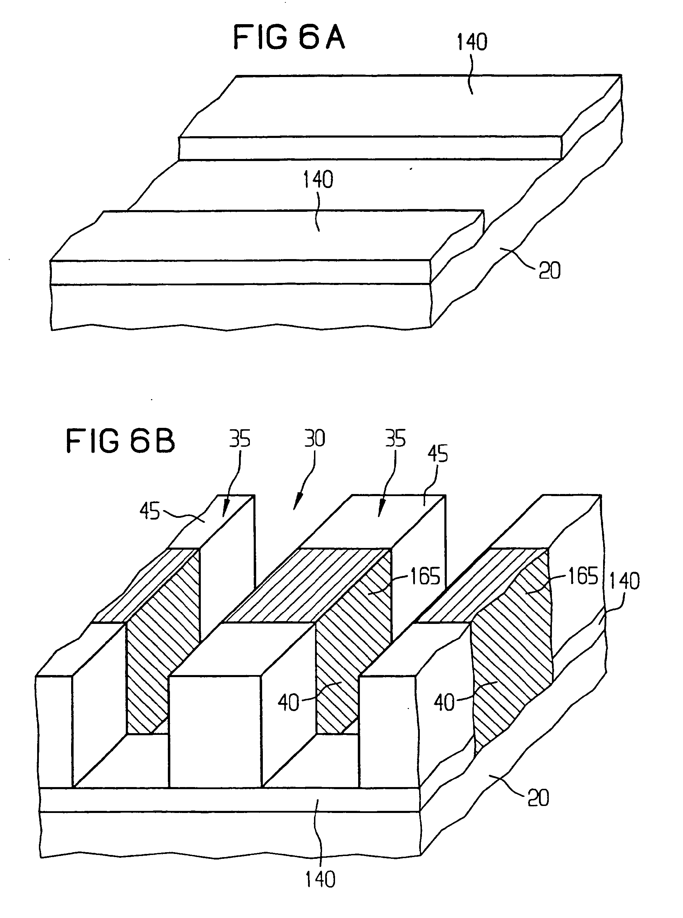

Wird ein Isolator als Grundsubstrat 20 verwendet, so können die zweiten Adreßleitungen 140 auch unmittelbar an der Unterseite 85 der Halbleitersubstratgebiete 45 angeordnet werden. Dies ist in den Figuren 6a und 6b dargestellt. Dazu werden zunächst die zweiten Adreßleitungen 140 streifenförmig auf das Grundsubstrat 20 aufgebracht. Der laterale Abstand zwischen den einzelnen zweiten Adreßleitung 140 sowie deren Breite entspricht dabei bereits dem Abstand der nachfolgend zu schaffenden Halbleitersubstratgebiete 45. Bevorzugt wird auch hier die Strukturbreite 1 F verwendet. Nachfolgend werden, wie bereits zuvor geschildert, die Isolationsgräben 165 und die Gräben 30 in Halbleitersubstrat 25 geätzt.

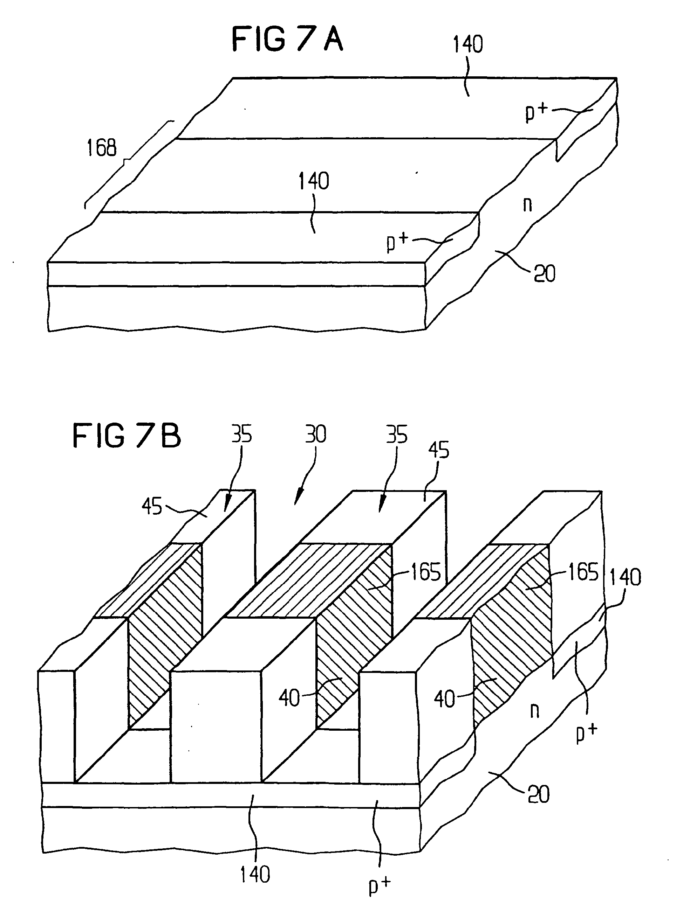

Die Ausbildung von zweiten Adreßleitungen 140 im Grundsubstrat 20 ist auch bei Verwendung eines aus einem Halbleitermaterial bestehenden Grundsubstrats 20 möglich. Zur Illustration wird auf die Figuren 7a und 7b verweisen. Besteht das Grundsubstrat 20 beispielsweise aus einem n-leitenden Material, so werden vor dem epitaktischen Auftragen des p-leitenden Halbleitersubstrats 25 streifenförmige zweite Adreßleitungen 140 in das Grundsubstrat 20 eingebracht. Diese sind dann bevorzugt p⁺-dotiert, das heißt, sie weisen eine relativ hohe Konzentration von Dotierstoffen auf. Dabei entsteht zwischen benachbarten zweiten Adreßleitungen 140 ein sperrender pnp-Übergang 168, der die Halbleitersubstratgebiete 45 an ihrer zum Grundsubstrat 20 gewandten Seite vollständig gegeneinander isoliert.

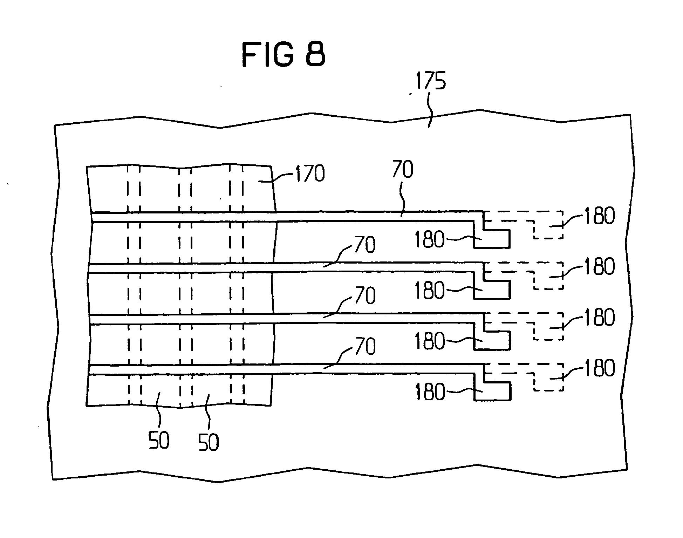

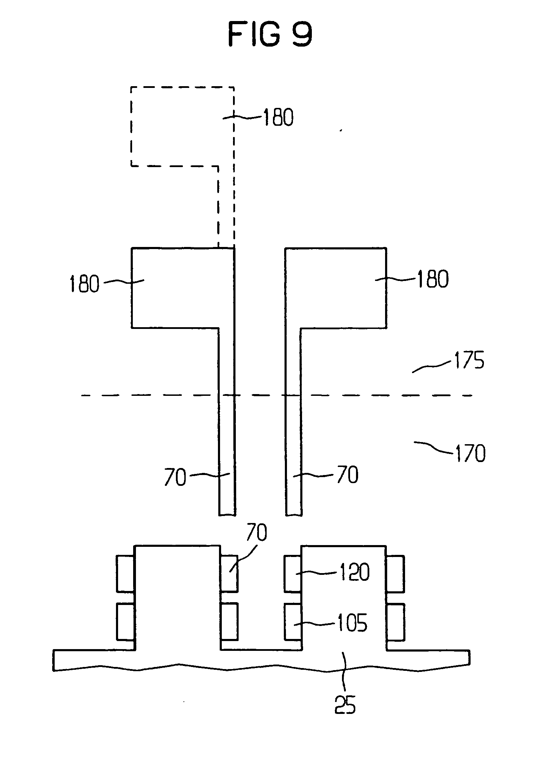

Das Kontaktieren der ersten Adreßleitungen ist in den Figuren 8 und 9 dargestellt. Bevorzugt sind die einzelnen Speicherzellen 50 in einem Speicherzellenfeld 170 zusammenfaßt. Aus diesem heraus führen die teilweise übereinander angeordneten ersten Adreßleitungen 70, die bis zur Peripherie 175 des Speicherzellenfeldes 170 reichen. Dort werden die einzelnen ersten Adreßleitungen 70 getrennt und enden jeweils in individuellen Kontaktgebieten 180. Da die ersten Adreßleitungen 170 konform abgeschieden wurden, müssen benachbarte und gleichzeitig gebildete erste Adreßleitungen 70, beispielsweise die ersten unteren Adreßleitungen 105, durch geeignete Maskentechnik voneinander getrennt werden. Insbesondere die in einem gemeinsamen Graben 30 verlaufenden Adreßleitungen 70 weisen an den Stirnseiten der Gräben 30 Verbindungen untereinander auf. Zum Durchtrennen dieser Verbindungen werden geeignete Trimm-Masken verwendet, die die nicht zu ätzende Gebiete der ersten Adreßleitungen überdecken. Im Gegensatz dazu bleiben die Verbindungsgebiete zwischen benachbarten ersten Adreßleitungen 70 von der Trimm-Maske unbedeckt und werden so durch einen nachfolgenden Ätzschritt entfernt. Die Ausbildung der individuellen Kontaktgebiete 180 erfolgt dagegen bevorzugt mittels sogenannter Pad-Masken. Durch diese werden die Kontaktgebiete 180 in ihrer Größe und Lage bestimmt.

## Patentansprüche

1. Elektrisch programmierbare, nichtflüchtige Speicherzellenanordnung mit einem Halbleitersubstrat (25), das einen ersten Leitungstyp aufweist,
- bei der im Halbleitersubstrat (25) eine Vielzahl von zueinander parallel verlaufenden Gräben (30) mit dazwischen liegenden Stegen (35) angeordnet ist, wobei die Gräben (30) an den Stegen (35) Seitenwände (75) aufweisen und an jeder Seitenwand (75) zumindest zwei erste Adressleitungen (70) längs der Gräben (30) verlaufen,
- die Stege (35) quer zu den Gräben (30) von Isolationsgebieten (40) durchzogen sind, die die Stege (35) in einzelne, gegeneinander isolierte Halbleitersubstratgebiete (45) vom ersten Leitungstyp trennen, wobei sich in jedem Halbleitersubstratgebiet (45) zumindest zwei erste Dotierungsgebiete (55) vom zweiten Leitungstyp befinden, die jeweils einer Speicherzelle (50) zugeordnet sind, und
- jedes Halbleitersubstratgebiet (45) mit zumindest einer zweiten Adressleitung (140) verbunden ist, wobei die zumindest eine zweite Adressleitung (140) quer zu den zumindest zwei ersten Adressleitungen (70) und von diesen beabstandet verläuft,
wobei die zumindest zwei ersten Dotierungsgebiete (55) vom zweiten Leitungstyp mit dem Halbleitersubstrat (25) vom ersten Leitungstyp einen unmittelbaren Übergang (60) zwischen den beiden Leitungstypen bilden, wobei durch diesen unmittelbaren Übergang (60) ein elektrischer Stromfluss zwischen den ersten Adressleitungen und der zweiten Adressleitung (140) im Halbleitersubstrat (25) unidirektional begrenzbar ist, und
- bei der sich zumindest eine Zwischenschicht (65), die Teil der Speicherzelle (50) ist, am Halbleitersubstrat (25) zwischen den ersten Adressleitungen und der zweiten Adressleitung (140) befindet,
**dadurch gekennzeichnet, dass**
die an jeder Seitenwand (75) der Vielzahl von Gräben (30) angeordneten mindestens zwei ersten Adressleitungen (70) eine erste untere Adressleitung (105) und eine darüber befindliche und von dieser getrennte erste obere Adressleitung (120) umfassen.

2. Speicherzellenanordnung nach Anspruch 1,
**dadurch gekennzeichnet, dass**
die ersten Adressleitungen (70) vom zweiten Leitungstyp sind und einen Dotierstoff vom zweiten Leitungstyp enthalten.

3. Speicherzellenanordnung Anspruch 2,
**dadurch gekennzeichnet, dass**
die ersten Adressleitungen (70) aus dotiertem Polysilizium mit einem Dotierstoffgehalt zwischen 10²⁰/cm³ und 10²²/cm³ bestehen.

4. Speicherzellenanordnung nach einem der vorherigen Ansprüche,
**dadurch gekennzeichnet, dass**
die ersten Adressleitungen (70) als seitliche Randstege an den Seitenwänden (75) der Gräben (30) ausgebildet sind.

5. Speicherzellenanordnung nach einem der vorherigen Ansprüche,
**dadurch gekennzeichnet, dass**
die Zwischenschicht (65) unmittelbar zwischen dem ersten Dotierungsgebiet (55) der Speicherzellen (50) und den ersten Adressleitungen (70) an den Seitenwänden (75) der Gräben (30) angeordnet ist.

6. Speicherzellenanordnung nach einem der vorherigen Ansprüche,
**dadurch gekennzeichnet, dass**
die Leitfähigkeit der Zwischenschicht (65) mittels eines Spannungs- oder eines Stromimpulses veränderbar ist und zum dauerhaften Speichern eines logischen Wertes in der Speicherzelle (50) dient.

7. Speicherzellenanordnung nach einem der vorherigen Ansprüche,
**dadurch gekennzeichnet, dass**
die Zwischenschicht (65) aus einem Oxid besteht.

8. Speicherzellenanordnung nach Anspruch 7,
**dadurch gekennzeichnet, dass**
das Oxid Siliziumoxid ist.

9. Speicherzellenanordnung nach einem der Ansprüche 1 bis 8,
**dadurch gekennzeichnet, dass**
an jeder Seitenwand (75) der Gräben (30) genau zwei erste Adressleitungen, umfassend eine erste untere Adressleitung (105) und eine darüber befindliche und von dieser getrennte erste obere Adressleitung (120), angeordnet sind.

10. Speicherzellenanordnung nach einem der Ansprüche 1 bis 9,
**dadurch gekennzeichnet, dass**
jedes Halbleitersubstratgebiet (45) zumindest ein zweites Dotierungsgebiet (80) vom ersten Leitungstyp mit einer gegenüber dem Halbleitersubstratgebiet (45) höheren Leitfähigkeit zum Kontaktieren mit der zweiten Adressleitung (140) aufweist.

11. Speicherzellenanordnung nach einem der Ansprüche 1 bis 10,
**dadurch gekennzeichnet, dass**
das Halbleitersubstrat (25) auf einem Grundsubstrat (20) angeordnet ist.

12. Speicherzellenanordnung nach Anspruch 11,
**dadurch gekennzeichnet, dass**
an der zum Grundsubstrat (20) gewandten Seite (85) der Halbleitersubstratgebiete (45) dritte Dotierungsgebiete (90) vom zweiten Leitungstyp zum Isolieren der Halbleitersubstratgebiete (45) gegeneinander angeordnet sind.

13. Speicherzellenanordnung nach Anspruch 11,
**dadurch gekennzeichnet, dass**
die zweiten Adressleitungen (140) am Grundsubstrat (20) unterhalb der Halbleitersubstratgebiete (45) angeordnet sind.

14. Speicherzellenanordnung nach einem der Ansprüche 1 bis 12,
**dadurch gekennzeichnet, dass**
die Gräben (30) mit einer isolierenden Schicht (130) befüllt sind, auf der sich die zweiten Adressleitungen (140) befinden.

15. Speicherzellenanordnung nach einem der Ansprüche 1 bis 14,
**dadurch gekennzeichnet, dass**
die Speicherzellen (50) in einem Speicherzellenfeld (170) zusammengefasst sind und die ersten Adressleitungen (70) aus diesem Speicherzellenfeld (170) heraus zur Peripherie (175) des Speicherzellenfeldes (170) führen und dort individuelle Kontaktgebiete (180) aufweisen.

16. Verfahren zum Herstellen einer elektrisch programmierbaren, nichtflüchtigen Speicherzellenanordnung mit folgenden Schritten:
- Bereitstellen eines Halbleitersubstrats (25) vom ersten Leitungstyp;
- Einbringen von zueinander parallel verlaufenden Isolationsgräben (165) in das Halbleitersubstrat;
- Auffüllen der Isolationsgräben (165) mit einem isolierenden Material, so dass Isolationsgebiete (40) in den Isolationsgräben (165) entstehen;
- Einbringen von zueinander parallel verlaufenden und senkrecht zu den Isolationsgräben (165) ausgerichteten Gräben (30) in das Halbleitersubstrat (25), wobei Stege (35) zwischen den Gräben (30) verbleiben, die durch die Isolationsgebiete (40) der Isolationsgräben (165) in einzelne Halbleitersubstratgebiete (45) vom ersten Leitungstyp unterteilt werden;
- Bilden einer Zwischenschicht (65) an den Seitenwänden (75) der Gräben (30);
- Aufbringen von ersten Adressleitungen (70) vom zweiten Leitungstyp auf die Seitenwände (75) der Gräben (30), wobei die ersten Adressleitungen (70) einen Dotierstoff vom zweiten Leitungstyp enthalten und wobei an jeder Seitenwand (75) der Gräben (30) mindestens zwei erste Adressleitungen (70), umfassend eine erste untere Adressleitung (105) und eine darüber befindliche und von dieser getrennte erste obere Adressleitung (120), ausgebildet werden; und
- Ausbilden zumindest einer zweiten Adressleitung (140), wobei die zweite Adressleitung (140) die ersten Adressleitungen (70; 105, 120) unter Beabstandung kreuzt,
- Temperieren des Halbleitersubstrats (25) bei einer vorgegebenen Diffusionstemperatur, so dass der Dotierstoff teilweise aus den ersten Adressleitungen (70) durch die Zwischenschicht (65) hindurch in die Halbleitersubstratgebiete (45) diffundiert und dort erste Dotierungsgebiete (55) vom zweiten Leitungstyp mit einem unmittelbaren Übergang (60) zum ersten Leitungstyp bildet.

17. Verfahren nach Anspruch 16,
**dadurch gekennzeichnet, dass**
an jeder Seitenwand (75) der Gräben (30) genau zwei erste Adressleitungen, umfassend eine erste untere Adressleitung (105) und eine darüber angeordnete und von dieser getrennte erste obere Adressleitung (120), gebildet werden.

18. Verfahren nach Anspruch 16 oder 17,
**dadurch gekennzeichnet, dass**
die Adressleitungen (70, 105, 120) in Form von selbstjustierten Randstegen gebildet werden.

19. Verfahren nach einem der Ansprüche 16 bis 18,
**dadurch gekennzeichnet, dass**
die Zwischenschicht (65) an jeder Seitenwand (75) selbstjustiert gebildet wird.

20. Verfahren nach einem der Ansprüche 16 bis 19,
**dadurch gekennzeichnet, dass**
das Halbleitersubstrat (25) epitaktisch auf einem Grundsubstrat (20) aufgebracht wird.

21. Verfahren nach Anspruch 20,
**dadurch gekennzeichnet, dass**
im Grundsubstrat (20) dritte Dotierungsgebiete (90) vom zweiten Leitfähigkeitstyp geschaffen werden, die sich unterhalb der Halbleitersubstratgebiete (45) befinden.

22. Verfahren nach Anspruch 20,
**dadurch gekennzeichnet, dass** die mindestens eine zweite Adressleitung (140) als am Grundsubstrat (20) zueinander parallel verlaufende zweite Adressleitungen (140) gebildet wird, die quer zu den ersten Adressleitungen (70) verlaufen.

23. Verfahren nach einem der Ansprüche 16 bis 21,
**dadurch gekennzeichnet, dass**
die Gräben (30) mit einer isolierenden Schicht (130) planarisierend aufgefüllt werden, auf der nachfolgend die zweiten Adressleitungen (140) quer zu den Gräben (30) verlaufend zum Kontaktieren der Halbleitersubstratgebiete (45) ausgebildet werden.

24. Verfahren nach Anspruch 23,
**dadurch gekennzeichnet, dass**
in jedes Halbleitersubstratgebiet (45) vor dem Aufbringen der zweiten Adressleitungen (140) ein zweites Dotierungsgebiet (80) vom ersten Leitungstyp eingebracht wird, dessen Leitfähigkeit höher als die Leitfähigkeit des Halbleitersubstrats (45) ist und zum Kontaktieren der Halbleitersubstratgebiete (45) mit den zweiten Adressleitungen (140) dient.

25. Verfahren nach einem der Ansprüche 16 bis 24,
**dadurch gekennzeichnet, dass**
die Speicherzellen (50) in einem Speicherzellenfeld (170) zusammengefasst werden, aus dem die ersten Adressleitungen (70) bis zur Peripherie (175) des Speicherzellenfeldes (170) herausgeführt und dort unter Verwendung einer Ätzmaske getrennt werden.

26. Verfahren nach Anspruch 25,
**dadurch gekennzeichnet, dass**
an der Peripherie (175) für jede erste Adressleitung (70) ein individuelles Kontaktgebiet (180) geschaffen wird.

27. Verfahren nach einem der Ansprüche 16 bis 26,
**dadurch gekennzeichnet, dass**
die ersten Adressleitungen (70) aus in situ dotiertem Polysilizium mit einer Dotierstoffkonzentration von 10²⁰/cm³ bis 10²²/cm³ bestehen.

28. Verfahren nach einem der Ansprüche 16 bis 27,
**dadurch gekennzeichnet, dass**
die Diffusionstemperatur oberhalb von 800°C liegt.

## Claims

1. Electrically programmable, non-volatile memory cell arrangement with a semiconductor substrate (25) comprising a first conduction type,
where a plurality of trenches (30) aligned in parallel to each other with ridges (35) lying in between is arranged in the semiconductor substrate (25), wherein the trenches (30) comprise side walls (75) at the ridges and at least two first address lines (70) pass alongside the trenches (30) at each side wall (75),
the ridges (35) are crossed crosswise by isolating regions (40) which divide the ridges (35) into individual semiconductor substrate regions (45) of the first conduction type being isolated from each other, wherein in each semiconductor substrate region (45) there are at least two first doping regions (55) of the second conduction type that belong to a memory cell (50), and
each semiconductor substrate region (34) is connected with at least one second address line (140), wherein the at least one second address line (140) runs crosswise in relation to the at least two first address lines (70) at a distance therefrom,
wherein the at least two first doping regions (55) of the second conduction type and the semiconductor substrate (25) of the first conduction type form an intermediate transition (60) between the two conduction types, wherein an electrical current between the first address lines and the second address line (140) in the semiconductor substrate (25) can be limited unidirectionally by that immediate transition, and
in which at least an intermediate layer (65) being part of the memory cell (50) is interposed at the semiconductor substrate (25) between the first address lines and the second address line (140),
**characterised in that**
the at least two first address lines (140) arranged at each side wall (75) of the plurality of trenches (30) comprise a first lower address line (105) and a first upper address line (120) lying atop thereof and being separated therefrom.

2. Memory cell arrangement according to claim 1, **characterised in that** the first address lines (70) are of the second conduction type and comprise a dopant of the second conduction type.

3. Memory cell arrangement according to claim 2, **characterised in that** the first address lines (70) consist of doped polysilicon with a dopant concentration between 10²⁰/cm³ and 10²²/cm³.

4. Memory cell arrangement according to any of the preceding claims, **characterised in that** the first address lines (70) are formed as side ridges at the side walls (75) of the trenches (30).

5. Memory cell arrangement according to any of the preceding claims, **characterised in that** the intermediate layer (65) is positioned immediately between the first doping region (55) of the memory cell (50) and the first address lines (70) at the side walls (75) of the trenches (30).

6. Memory cell arrangement according to any of the preceding claims, **characterised in that** the conductivity of the intermediate layer (65) is adjustable by means of a voltage or a current pulse and serves for permanent saving of a logic value in the memory cell (50).

7. Memory cell arrangement according to any of the preceding claims, **characterised in that** the intermediate layer (65) consists of an oxide.

8. Memory cell arrangement according to claim 7, **characterised in that** the oxide is silicon oxide.

9. Memory cell arrangement according to one of the claims 1 to 8, **characterised in that** exactly two first address lines are positioned at each side wall (75) of the trenches (30), including a first lower address line (105) and a first upper address line (120) lying atop thereof and being separated therefrom.

10. Memory cell arrangement according to one of the claims 1 to 9, **characterised in that** every semiconductor substrate region (45) comprises at least a second doping region (80) of the first conduction type of a higher conductivity with respect to the semiconductor substrate region (45) for contacting the second address line (140).

11. Memory cell arrangement according to one of the claims 1 to 10, **characterised in that** the semiconductor substrate (25) is arranged on a base substrate (20).

12. Memory cell arrangement according to claim 11, **characterised in that** third doping regions (90) of the second conduction type are arranged at the side (85) of the semiconductor substrate regions (45) that faces the base substrate (20) for isolating the semiconductor substrate regions (45) from each other.

13. Memory cell arrangement according to claim 11, **characterised in that** the second address lines (140) are arranged on the base substrate (20) below the semiconductor substrate regions (45).

14. Memory cell arrangement according to one of the claims 1 to 12, **characterised in that** the trenches (30) are filled with an isolating layer (130) on which the second address lines (140) are located.

15. Memory cell arrangement according to one of the claims 1 to 14, **characterised in that** the memory cells (50) are combined in a memory cell array (170) and the fist address lines (70) lead outwards from that memory cell array (170) to the periphery (175) of the memory cell array (170) and comprise individual contacts (180) there.

16. Method for manufacturing of a electrically programmable, non-volatile memory cell arrangement comprising following steps:
providing a semiconductor substrate (25) of the first conduction type;
introducing isolation trenches (165) into the semiconductor substrate (25) running parallel to each other;
filling up the isolation trenches (165) with an isolating material such that isolation regions (40) are formed in the isolation trenches (165);
introducing trenches (30) into the semiconductor substrate (25) running parallel to each other and aligned perpendicular to the isolation trenches (165), wherein ridges (35) remain between the trenches (30) that are divided into individual semiconductor substrate regions (45) of the first conduction type by the isolation regions (40) of the isolation trenches (165);
forming an intermediate layer (65) at the side walls (75) of the trenches (30);
applying first address lines (70) of the second conduction type onto the side walls (75) of the trenches (30), wherein the first address lines (70) comprise a dopant of the second conduction type and wherein at least two first address lines (70), including a first lower address line (105) and a first upper address line (120) lying atop thereof and being separated therefrom, are provided at each side wall (75) of the trenches (30); and
providing at least one second address line (140), wherein the second address line (140) crosses the first address lines (70, 105, 120) at a distance therefrom;
tempering the semiconductor substrate (25) at a given temperature such that the dopant partially diffuses from the first address lines (70) through the intermediate layer (65) into the semiconductor substrate regions (45) and forms first doping regions (55) of the second conduction type there with an immediate transition (60) to the first conduction type.

17. Method according to claim 16, **characterised in that** exactly two first address lines are formed at each side wall (75) of the trenches (30), including a first lower address line (105) and a first upper address line (120) lying atop thereof and being isolated therefrom.

18. Method according to claim 16 or 17, **characterised in that** the address lines (70, 105, 120) are formed in the form of self-aligned side ridges.

19. Method according to one of the claims 16 to 18, **characterised in that** the intermediate layer (65) is formed at each side wall (65) in a self-aligned manner.

20. Method according to one of the claims 16 to 19, **characterised in that** the semiconductor substrate (25) is epitaxially applied onto a base substrate (20).

21. Method according to claim 20, **characterised in that** third doping regions (90) of the second conductivity type are created in the base substrate (20) which are located underneath the semiconductor substrate regions (45).

22. Method according to claim 20, **characterised in that** at least one second address line (140) is formed as second address lines (140) running parallel to each other on the base substrate (20) that run crosswise in relation to the first address lines (70).

23. Method according to one of the claims 16 to 21, **characterised in that** the trenches (30) are filled up with an isolating layer (130) until being flat, on which isolating layer (130) the second address lines (140) running perpendicular to the trenches (30) are subsequently formed for contacting the semiconductor substrate regions (45).

24. Method according to claim 23, **characterised in that** before applying the second address lines (140) a second doping region (80) of the first conduction type is formed into each semiconductor substrate region (45), the conductivity of which is higher than the conductivity of the semiconductor substrate (45) and that serves for contacting the semiconductor substrate regions (45) with the second address lines (140).

25. Method according to one of the claims 16 to 24, **characterised in that** the memory cells (50) are combined in a memory cell array (170) from which the first address lines (70) are directed outwards to the periphery (175) of the memory cell array (170) and are separated there by the use of an etching mask.

26. Method according to claim 25, **characterised in that** an individual contact region (180) is formed at the periphery (175) for each fist address line (70).

27. Method according to one of the claims 16 to 26, **characterised in that** the first address lines (70) consist of polysilicon doped in situ with a dopant concentration in the range from 10²⁰/cm³ to 10²²/cm³.

28. Method according to one of the claims 16 to 27, **characterised in that** the diffusion temperature lies above 800°C.

## Revendications

1. Agencement de cellules de mémoire non-volatiles, programmables électriquement, comprenant un substrat (25) semiconducteur, qui a un premier type de conductivité
- dans lequel il est ménagé dans le substrat (25) semiconducteur une pluralité de sillons (30) s'étendant parallèlement entre eux avec des nervures (35) se trouvant entre eux, les sillons (30) ayant sur les nervures (35) des parois (75) latérales et, pour chaque paroi (75) latérale, au moins deux premières lignes (70) d'adresse s'étendent le long des sillons (30),
- les nervures sont traversées transversalement aux sillons (30) par des zones (40) isolantes, qui séparent les nervures (35) en des zones (45) de substrat semiconducteur individuelles, isolées les unes par rapport aux autres du premier type de conductivité, au moins deux premières zones (55) de dopage du deuxième type de conductivité, qui sont associées respectivement à une cellule (50) de mémoire, se trouvant dans chaque zone (45) du substrat semiconducteur, et
- chaque zone (45) du substrat semiconducteur est reliée à au moins une deuxième ligne (140) d'adresse, la au moins une deuxième ligne (140) d'adresse s'étendant transversalement aux au moins deux premières lignes (70) d'adresse et à distance de celles-ci,
dans lequel les deux premières zones (55) de dopage du deuxième type de conductivité forment avec le substrat (25) semiconducteur du premier type de conductivité une jonction (60) directe entre les deux types de conductivité, un flux de courant électrique entre les premières lignes d'adresse et la deuxième ligne (140) pouvant être limité unidirectionnellement dans le substrat (25) semiconducteur par cette jonction (60) directe, et
- dans lequel au moins une couche (65) intermédiaire, qui fait partie de la cellule (50) de mémoire, se trouve dans le substrat (25) semiconducteur entre les premières lignes d'adresse et la deuxième ligne (140) d'adresse,
**caractérisé en ce que**
les au moins deux premières lignes (70) d'adresse disposées sur chaque paroi (75) latérale de la pluralité de sillons (30) comprennent une première ligne (105) d'adresse inférieure et une première ligne (120) supérieure se trouvant au-dessus et en étant séparée.

2. Agencement de cellules de mémoire suivant la revendication 1,
**caractérisé en ce que**
les premières lignes (70) d'adresse sont du deuxième type de conductivité et contiennent une substance de dopage du deuxième type de conductivité.

3. Agencement de cellules de mémoire suivant la revendication 2,
**caractérisé en ce que**
les premières lignes (70) d'adresse sont en polysilicium dopé ayant une teneur en substance de dopage comprise entre 10²⁰/cm³ et 10²²/cm³.

4. Agencement de cellules de mémoire suivant l'une des revendications précédentes,
**caractérisé en ce que**
les premières lignes (70) d'adresse sont constituées sous la forme de nervures marginales latérales sur les parois (75) latérales des sillons (30).

5. Agencement de cellules de mémoire suivant l'une des revendications précédentes,
**caractérisé en ce que**
la couche (65) intermédiaire est disposée directement entre la première zone (55) de dopage des cellules (50) de mémoire et les premières lignes (70) d'adresse sur les parois (75) latérales des sillons (30).

6. Agencement de cellules de mémoire suivant l'une des revendications précédentes,
**caractérisé en ce que**
la conductivité de la couche (65) intermédiaire peut être modifiée au moyen d'une impulsion de tension ou d'une impulsion de courant et sert à la mémorisation permanente d'une valeur logique dans la cellule (50) de mémoire.

7. Agencement de cellules de mémoire suivant l'une des revendications précédentes,
**caractérisé en ce que**
la couche (65) intermédiaire est en un oxyde.

8. Agencement de cellules de mémoire suivant la revendication 7,
**caractérisé en ce que**
l'oxyde est l'oxyde de silicium.

9. Agencement de cellules de mémoire suivant l'une des revendications 1 à 8,
**caractérisé en ce que**
sur chaque paroi (75) latérale des sillons (30) sont disposées exactement deux premières lignes d'adresse comprenant une première ligne (105) d'adresse inférieure et une première ligne (120) d'adresse supérieure se trouvant au-dessous et en étant séparée.

10. Agencement de cellules de mémoire suivant l'une des revendications 1 à 9,
**caractérisé en ce que**
chaque zone (45) de substrat semiconducteur comporte au moins une deuxième zone (80) de dopage du premier type de conductivité ayant une conductivité plus grande que la zone (45) du substrat semiconducteur pour la mise en contact avec la deuxième ligne (140) d'adresse.

11. Agencement de cellules de mémoire suivant l'une des revendications 1 à 10,
**caractérisé en ce que**
le substrat (25) semiconducteur est disposé sur un substrat (20) de base.

12. Agencement de cellules de mémoire suivant la revendication 11,
**caractérisé en ce que**
sur la face (85) tournée vers le substrat (20) de base des zones (45) du substrat semiconducteur, sont disposées des troisièmes zones (90) de dopage du deuxième type de conductivité pour isoler mutuellement les zones (45) du substrat semiconducteur.

13. Agencement de cellules de mémoire suivant la revendication 11,
**caractérisé en ce que**
les deuxièmes lignes (140) d'adresse sont disposées dans le substrat (20) de base en dessous des zones (45) du substrat semiconducteur.

14. Agencement de cellules de mémoire suivant l'une des revendications 1 à 12,
**caractérisé en ce que**
les sillons (30) sont remplis d'une couche (130) isolante, sur laquelle se trouvent les deuxièmes lignes (140) d'adresse.

15. Agencement de cellules de mémoire suivant l'une des revendications 1 à 14,
**caractérisé en ce que**
les cellules (50) de mémoire sont rassemblées dans un champ (170) de cellules de mémoire et les premières lignes (70) d'adresse vont de ce champ (170) de cellules de mémoire à la périphérie (175) du champ (170) de cellules de mémoire et y ont des zones (180) individuelles de contact.

16. Procédé de production d'un agencement de cellules de mémoire non volatiles, programmables électriquement, comprenant les stades dans lesquels :
- on se procure un substrat (25) semiconducteur du premier type de conductivité ;
- on ménage dans le substrat semiconducteur des sillons (165) isolants s'étendant parallèlement les uns aux autres ;
- on remplit les sillons (165) isolants d'un matériau isolant de manière à créer des zones (40) isolantes dans les sillons (165) isolants ;
- on ménage dans le substrat (25) semiconducteur des sillons (30) s'étendant parallèlement entre eux et dirigés perpendiculairement aux sillons (165) isolants, des nervures (35) subsistant entre les sillons (30), nervures qui sont subdivisées par les zones (40) isolantes des sillons (165) isolants en des zones (45) individuelles de substrat semiconducteur du premier type de conductivité ;
- on forme une couche (65) intermédiaire sur les parois (75) latérales des sillons (30) ;
- on dépose des premières lignes (70) d'adresse du deuxième type de conductivité sur les parois (75) latérales du sillon (30), les premières lignes (70) d'adresse contenant une substance de dopage du deuxième type de conductivité et sur chaque paroi (75) latérale du sillon (30) sont formées au moins deux premières lignes (70) d'adresse, comprenant une première ligne (105) d'adresse inférieure et une première ligne (120) d'adresse supérieure se trouvant au-dessous et en étant séparée ; et
- on forme au moins une deuxième ligne (140) d'adresse, la deuxième ligne (140) d'adresse croisant à distance les premières lignes (70, 105, 120) d'adresse,
- on met en température le substrat (25) semiconducteur à une température de diffusion prescrite, de sorte que la substance de dopage diffuse en partie des premières lignes (70) d'adresse dans les zones (45) du substrat semiconducteur en traversant la couche (65) intermédiaire et y forme des premières (55) zones de dopage du deuxième type de conductivité ayant une jonction (60) directe avec le premier type de conductivité.

17. Procédé suivant la revendication 16,
**caractérisé en ce que**
on forme sur sa paroi (75) latérale du sillon (30) exactement deux premières lignes d'adresse comprenant une première ligne (105) d'adresse inférieure et une première ligne (120) d'adresse supérieure se trouvant au-dessus et en étant séparée.

18. Procédé suivant la revendication 16 ou 17,
**caractérisé en ce que**
on forme les lignes (70, 105, 120) d'adresse sous la forme de nervures marginales à auto-alignement.

19. Procédé suivant l'une des revendications 16 à 18,
**caractérisé en ce que**
on forme une couche (65) intermédiaire d'une manière auto-alignée sur chaque paroi (75) latérale.

20. Procédé suivant l'une des revendications 16 à 19,
**caractérisé en ce que**
on dépose le substrat (25) semiconducteur par épitaxie sur un substrat (20) de base.

21. Procédé suivant la revendication 20,
**caractérisé en ce que**
on ménage dans le substrat (20) de base des troisièmes zones (90) de dopage du deuxième type de conductivité, qui se trouvent en dessous des zones (45) du substrat semiconducteur.

22. Procédé suivant la revendication 20,
**caractérisé en ce que**
on forme au moins une deuxième ligne (140) d'adresse sous la forme de deuxièmes lignes (140) d'adresse s'étendant parallèlement les unes aux autres dans le substrat (20) de base et s'étendant transversalement aux premières lignes (70) d'adresse.

23. Procédé suivant l'une des revendications 16 à 21,
**caractérisé en ce que**
on remplit les sillons (30) d'une couche (130) isolante avec planarisation, sur laquelle ensuite on forme les deuxièmes lignes (140) d'adresse s'étendant transversalement aux sillons (30) pour la mise en contact des zones (45) du substrat semiconducteur.

24. Procédé suivant la revendication 23,
**caractérisé en ce que**
on ménage dans chaque zone (45) du substrat semiconducteur, avant le dépôt des deuxièmes lignes (140) d'adresse, une deuxième zone (80) de dopage du premier type de conductivité, dont la conductivité est plus grande que la conductivité du substrat (45) semiconducteur et qui sert à la mise en contact des zones (45) du substrat semiconducteur avec les deuxièmes lignes (140) d'adresse.

25. Procédé suivant l'une des revendications 16 à 24,
**caractérisé en ce que**
les cellules (50) de mémoire sont rassemblées en un champ (170) de cellules de mémoire, dont les premières lignes (70) d'adresse sortent jusqu'à la périphérie (175) du champ (170) de cellules de mémoire et y sont séparées en utilisant un masque d'attaque.

26. Procédé suivant la revendication 25,
**caractérisé en ce que**
on ménage une zone (180) individuelle de contact à la périphérie (175) pour chaque première ligne (70) d'adresse.

27. Procédé suivant l'une des revendications 16 à 26,
**caractérisé en ce que**
les premières lignes (70) d'adresse sont en polysilicium dopé in situ en ayant une concentration de substance au dopage de 10²⁰/cm³ et 10²²/cm³.

28. Procédé suivant l'une des revendications 16 à 27,
**caractérisé en ce que**
la température de diffusion est supérieure à 800°C.
